(19) Europäisches Patentamt
European Patent Office
Office européen des brevets

(11) **EP 3 767 678 A1**

(12) **DEMANDE DE BREVET EUROPEEN**

(43) Date de publication:
**20.01.2021 Bulletin 2021/03**

(51) Int Cl.:
*H01L 27/30* (2006.01)     *H01L 51/44* (2006.01)
*H04N 5/369* (2011.01)     *H01L 27/146* (2006.01)

(21) Numéro de dépôt: **20186099.6**

(22) Date de dépôt: **16.07.2020**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **19.07.2019 FR 1908252**

(71) Demandeur: **ISORG**
**87068 Limoges Cedex 3 (FR)**

(72) Inventeurs:
• DUPOIRON, Camille
**38000 GRENOBLE (FR)**
• BOUTHINON, Benjamin
**38000 GRENOBLE (FR)**

(74) Mandataire: **Cabinet Beaumont**
**4, Place Robert Schuman**
**B.P. 1529**
**38025 Grenoble Cedex 1 (FR)**

(54) **PIXEL DE CAPTEUR D'IMAGES**

(57) La présente description concerne un pixel (50, 52, 54, 56) comportant un support CMOS (8) et au moins deux photodétecteurs organiques (50A, 50B, 50C, 50D, 52A, 52B, 52C, 52D, 54A, 54B, 54C, 54D, 56A, 56B, 56C, 56D), dans lequel une même lentille (58) est à l'aplomb desdits photodétecteurs organiques.

[Fig. 1]

EP 3 767 678 A1

**Description**

Domaine technique

La présente demande concerne un capteur d'images ou imageur électronique.

Technique antérieure

Des capteurs d'images sont actuellement utilisés dans de nombreux domaines, en particulier dans les dispositifs électroniques. On retrouve notamment des capteurs d'images dans des applications d'interface homme-machine et de prise d'images. Des domaines d'utilisation de tels capteurs d'images sont, par exemple, les téléphones intelligents, l'automobile, les drones, la robotique et les systèmes à réalité virtuelle ou augmentée.

Dans certaines applications, un même dispositif électronique peut disposer de plusieurs capteurs d'images de différents types. Un tel dispositif peut ainsi comporter, par exemple, un premier capteur d'images en couleur, un deuxième capteur d'images infrarouge, un troisième capteur d'images permettant d'évaluer une distance, par rapport au dispositif, de différents points d'une scène ou d'un sujet, etc.

Cette multiplicité de capteurs d'images embarqués dans un même dispositif est, par nature, peu compatible avec les contraintes actuelles de miniaturisation de ces dispositifs.

Le document DE102016102111 décrit un capteur d'images et un dispositif d'imagerie comportant ce capteur.

Le document US2017257587 décrit un dispositif d'imagerie à semiconducteur, un procédé de commande de ce dispositif et un dispositif électronique.

Le document EP3209012 décrit un dispositif électronique et son procédé de fonctionnement.

Résumé de l'invention

Il existe un besoin d'améliorer les capteurs d'images existants.

Un mode de réalisation pallie tout ou partie des inconvénients des capteurs d'images connus.

Un mode de réalisation prévoit un pixel comportant :

un support CMOS ; et
au moins deux photodétecteurs organiques,
dans lequel une même lentille est à l'aplomb desdits photodétecteurs organiques.

Un mode de réalisation prévoit un capteur d'images comportant plusieurs pixels tels que décrits.

Un mode de réalisation prévoit un procédé de fabrication d'un tel pixel ou d'un tel capteur d'images, comprenant des étapes consistant à :

prévoir un support CMOS ;
réaliser au moins deux photodétecteurs organiques par pixel ; et
réaliser une même lentille à l'aplomb des photodétecteurs organiques du ou de chaque pixel.

Selon un mode de réalisation, lesdits photodétecteurs organiques sont coplanaires.

Selon un mode de réalisation, lesdits photodétecteurs organiques sont séparés les uns des autres par un diélectrique.

Selon un mode de réalisation, chaque photodétecteur organique comporte une première électrode, distincte de premières électrodes des autres photodétecteurs organiques, formée en surface du support CMOS.

Selon un mode de réalisation, chaque première électrode est reliée, de préférence connectée, à un circuit de lecture, chaque circuit de lecture comportant, de préférence, trois transistors formés dans le support CMOS.

Selon un mode de réalisation, lesdits photodétecteurs organiques sont adaptés à évaluer une distance par temps de vol.

Selon un mode de réalisation, le pixel ou le capteur tel que décrit est adapté à fonctionner :

dans une partie du spectre infrarouge ;
en lumière structurée ;
en imagerie à grande gamme dynamique, HDR ; et/ou
avec suppression de fond.

Selon un mode de réalisation, chaque pixel comporte en outre, sous la lentille, un filtre couleur laissant passer les ondes électromagnétiques dans une plage de fréquences du spectre visible et dans le spectre infrarouge.

Selon un mode de réalisation, le capteur d'images tel que décrit est adapté à capter une image couleur.

Selon un mode de réalisation, chaque pixel comporte exactement :

un premier photodétecteur organique ;
un deuxième photodétecteur organique ; et
deux troisièmes photodétecteurs organiques.

Selon un mode de réalisation, pour chaque pixel, le premier photodétecteur organique, le deuxième photodétecteur organique et les troisièmes photodétecteurs organiques sont de forme carrée et s'inscrivent conjointement dans un carré.

Selon un mode de réalisation, pour chaque pixel :

le premier photodétecteur organique est connecté à une deuxième électrode ;
le deuxième photodétecteur organique est connecté à une troisième électrode ; et

les troisièmes photodétecteurs organiques sont connectés à une même quatrième électrode.

Selon un mode de réalisation :

le premier photodétecteur organique et le deuxième photodétecteur organique comportent une première couche active constituée d'un même premier matériau ; et
les troisièmes photodétecteurs organiques comportent une deuxième couche active constituée d'un deuxième matériau.

Selon un mode de réalisation, le premier matériau est identique au deuxième matériau, ledit matériau étant adapté à absorber les ondes électromagnétiques du spectre visible et d'une partie du spectre infrarouge.
Selon un mode de réalisation, le premier matériau est différent du deuxième matériau, ledit premier matériau étant adapté à absorber les ondes électromagnétiques d'une partie du spectre infrarouge et ledit deuxième matériau étant adapté à absorber les ondes électromagnétiques du spectre visible.
Selon un mode de réalisation :

la deuxième électrode est commune à tous les premiers photodétecteurs organiques des pixels du capteur ;
la troisième électrode est commune à tous les deuxièmes photodétecteurs organiques des pixels du capteur ; et
la quatrième électrode est commune à tous les troisièmes photodétecteurs organiques des pixels du capteur.

Brève description des dessins

Ces caractéristiques et avantages, ainsi que d'autres, seront exposés en détail dans la description suivante de modes de réalisation et modes de mise en œuvre particuliers faite à titre non limitatif en relation avec les figures jointes parmi lesquelles :

La figure 1 est une vue en perspective éclatée, schématique et partielle, d'un mode de réalisation d'un capteur d'images ;

La figure 2 est une vue de dessus, schématique et partielle, du capteur d'images de la figure 1 ;

La figure 3 est un schéma électrique d'un mode de réalisation de circuits de lecture d'un pixel du capteur d'images des figures 1 et 2 ;

La figure 4 est un chronogramme de signaux d'un exemple de fonctionnement du capteur d'images ayant les circuits de lecture de la figure 3 ;

La figure 5 est une vue en coupe, schématique et partielle, d'une étape d'un mode de mise en œuvre d'un procédé de réalisation du capteur d'images des figures 1 et 2 ;

La figure 6 est une vue en coupe, schématique et partielle, d'une autre étape du mode de mise en œuvre du procédé de réalisation du capteur d'images des figures 1 et 2 ;

La figure 7 est une vue en coupe, schématique et partielle, d'encore une autre étape du mode de mise en œuvre du procédé de réalisation du capteur d'images des figures 1 et 2 ;

La figure 8 est une vue en coupe, schématique et partielle, d'encore une autre étape du mode de mise en œuvre du procédé de réalisation du capteur d'images des figures 1 et 2 ;

La figure 9 est une vue en coupe, schématique et partielle, d'encore une autre étape du mode de mise en œuvre du procédé de réalisation du capteur d'images des figures 1 et 2 ;

La figure 10 est une vue en coupe, schématique et partielle, d'encore une autre étape du mode de mise en œuvre du procédé de réalisation du capteur d'images des figures 1 et 2 ;

La figure 11 est une vue en coupe, schématique et partielle, d'encore une autre étape du mode de mise en œuvre du procédé de réalisation du capteur d'images des figures 1 et 2 ;

La figure 12 est une vue en coupe, schématique et partielle, d'encore une autre étape du mode de mise en œuvre du procédé de réalisation du capteur d'images des figures 1 et 2 ;

La figure 13 est une vue en coupe, schématique et partielle, d'encore une autre étape du mode de mise en œuvre du procédé de réalisation du capteur d'images des figures 1 et 2 ;

La figure 14 est une vue en coupe, schématique et partielle, d'encore une autre étape du mode de mise en œuvre du procédé de réalisation du capteur d'images des figures 1 et 2 ;

La figure 15 est une vue en coupe, schématique et partielle, d'encore une autre étape du mode de mise en œuvre du procédé de réalisation du capteur d'images des figures 1 et 2 ;

La figure 16 est une vue en coupe, schématique et partielle, d'encore une autre étape du mode de mise en œuvre du procédé de réalisation du capteur d'images des figures 1 et 2 ;

La figure 17 est une vue en coupe selon le plan CC, schématique et partielle, du capteur d'images des figures 1 et 2 ;

La figure 18 illustre, par des vues (A), (B) et (C), un mode de réalisation d'électrodes du capteur d'images des figures 1 et 2 ;

La figure 19 est une vue en coupe, schématique et partielle, d'une étape d'un autre mode de mise en œuvre d'un procédé de réalisation du capteur d'images des figures 1 et 2 ;

La figure 20 est une vue en coupe, schématique et partielle, d'une autre étape de l'autre mode de mise en œuvre du procédé de réalisation du capteur d'images des figures 1 et 2 ;

La figure 21 est une vue en coupe, schématique et partielle, d'encore une autre étape de l'autre mode de mise en œuvre du procédé de réalisation du capteur d'images des figures 1 et 2 ;

La figure 22 est une vue en coupe, schématique et partielle, d'encore une autre étape de l'autre mode de mise en œuvre du procédé de réalisation du capteur d'images des figures 1 et 2 ;

La figure 23 est une vue en coupe, schématique et partielle, d'encore une autre étape de l'autre mode de mise en œuvre du procédé de réalisation du capteur d'images des figures 1 et 2 ;

La figure 24 est une vue en coupe, schématique et partielle, d'encore une autre étape de l'autre mode de mise en œuvre du procédé de réalisation du capteur d'images des figures 1 et 2 ; et

La figure 25 est une vue en coupe, schématique et partielle, d'un autre mode de réalisation d'un capteur d'images.

## Description des modes de réalisation

De mêmes éléments ont été désignés par de mêmes références dans les différentes figures. En particulier, les éléments structurels et/ou fonctionnels communs aux différents modes de réalisation et modes de mise en œuvre peuvent présenter les mêmes références et peuvent disposer de propriétés structurelles, dimensionnelles et matérielles identiques.

Par souci de clarté, seuls les étapes et éléments utiles à la compréhension des modes de réalisation et modes de mise en œuvre décrits ont été représentés et sont détaillés. En particulier, l'utilisation faite des capteurs d'images décrits ci-après n'a pas été détaillée.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la présente description, on considère, sauf mention contraire, que les termes « isolant » et « conducteur » signifient respectivement « isolant électriquement » et « conducteur électriquement ».

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un capteur d'images dans une position normale d'utilisation.

Sauf précision contraire, les expressions "environ", "approximativement", "sensiblement", et "de l'ordre de" signifient à 10 % près, de préférence à 5 % près.

La transmittance d'une couche à un rayonnement correspond au rapport entre l'intensité du rayonnement sortant de la couche et l'intensité du rayonnement entrant dans la couche, les rayons du rayonnement entrant étant perpendiculaires à la couche. Dans la suite de la description, une couche ou un film est dit opaque à un rayonnement lorsque la transmittance du rayonnement au travers de la couche ou du film est inférieure à 10 %. Dans la suite de la description, une couche ou un film est dit transparent à un rayonnement lorsque la transmittance du rayonnement au travers de la couche ou du film est supérieure à 10 %.

Dans la suite de la description, on appelle lumière visible un rayonnement électromagnétique dont la longueur d'onde est comprise entre 400 nm et 700 nm et on appelle rayonnement infrarouge un rayonnement électromagnétique dont la longueur d'onde est comprise entre 700 nm et 1 mm. Dans le rayonnement infrarouge, on distingue notamment le rayonnement infrarouge proche dont la longueur d'onde est comprise entre 700 nm et 1,7 μm.

Un pixel d'une image correspond à l'élément unitaire de l'image captée par un capteur d'images. Lorsque le dispositif optoélectronique est un capteur d'images couleur, il comprend en général, pour chaque pixel de l'image couleur à acquérir, au moins trois composants. Ces trois composants font chacun l'acquisition d'un rayonnement lumineux sensiblement dans une seule couleur, c'est-à-dire dans une plage de longueurs d'onde de largeur inférieure à 130 nm (par exemple, le rouge, le vert et le bleu). Chaque composant peut comprendre notamment au moins un photodétecteur.

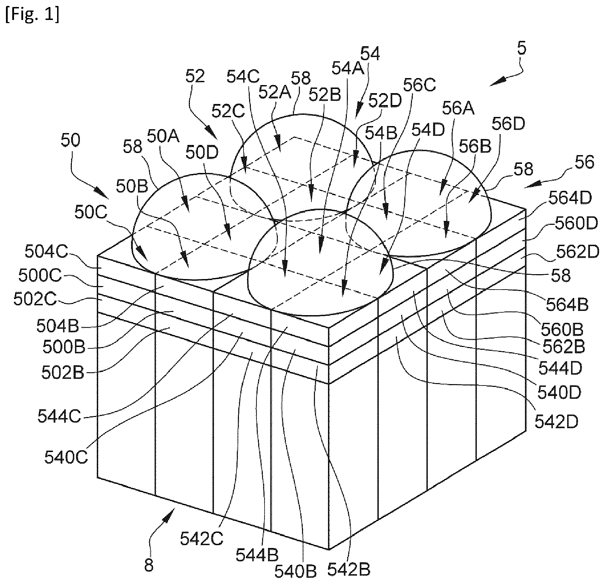

La figure 1 est une vue en perspective éclatée, schématique et partielle, d'un mode de réalisation d'un capteur d'images 5.

Ce capteur d'images 5 comporte une matrice de pixels coplanaires. Pour simplifier, seuls quatre pixels 50, 52, 54 et 56 du capteur d'images 5 ont été représentés en figure 1 étant entendu que, en pratique, le capteur d'images 5 peut comporter davantage de pixels. Le capteur d'images 5 comporte, par exemple, plusieurs millions voire plusieurs dizaines de millions de pixels.

Selon ce mode de réalisation, les pixels 50, 52, 54 et 56 sont situés en surface d'un support CMOS 8, par exemple un morceau de plaquette de silicium sur et à l'intérieur duquel des circuits intégrés (non représentés) ont été réalisés en technologie CMOS (Complementary Metal Oxide Semiconductor). Ces circuits intégrés forment, dans cet exemple, une matrice de circuits de lecture associés aux pixels 50, 52, 54 et 56 du capteur d'images 5. Par circuit de lecture, on entend un ensemble de transistors de lecture, d'adressage et de commande associés à chaque pixel.

Dans le capteur d'images 5, chaque pixel comporte un premier photodétecteur, repéré par le suffixe « A », un deuxième photodétecteur, repéré par le suffixe « B » et deux troisièmes photodétecteurs, repérés par les suffixes « C » et « D ». Plus précisément, dans l'exemple de la figure 1 :

le pixel 50 comporte un premier photodétecteur 50A, un deuxième photodétecteur 50B et deux troisièmes photodétecteurs 50C et 50D ;
le pixel 52 comporte un premier photodétecteur 52A, un deuxième photodétecteur 52B et deux troisièmes photodétecteurs 52C et 52D ;
le pixel 54 comporte un premier photodétecteur 54A, un deuxième photodétecteur 54B et deux troisièmes photodétecteurs 54C et 54D ; et
le pixel 56 comporte un premier photodétecteur 56A, un deuxième photodétecteur 56B et deux troisièmes photodétecteurs 56C et 56D.

Ces photodétecteurs 50A, 50B, 50C, 50D, 52A, 52B, 52C, 52D, 54A, 54B, 54C, 54D, 56A, 56B, 56C et 56D peuvent correspondre à des photodiodes organiques (Organic Photodiode - OPD) ou à des photorésistances organiques. Dans la suite de la description, on considère que les photodétecteurs des pixels du capteur d'images 5 correspondent à des photodiodes organiques.

Dans la représentation simplifiée de la figure 1, chaque photodétecteur comporte une couche active, ou couche photosensible, comprise ou en « sandwich » entre deux électrodes. Plus précisément, dans l'exemple de la figure 1 où seules des faces latérales des photodétecteurs organiques 50B, 50C, 54B, 54C, 54D, 56B et 56D sont visibles :

le deuxième photodétecteur 50B est constitué d'une couche active 500B comprise entre une première électrode 502B et une deuxième électrode 504B ;

le troisième photodétecteur 50C est constitué d'une couche active 500C comprise entre une première électrode 502C et une deuxième électrode 504C ;
le deuxième photodétecteur 54B est constitué d'une couche active 540B comprise entre une première électrode 542B et une deuxième électrode 544B ;
le troisième photodétecteur 54C est constitué d'une couche active 540C comprise entre une première électrode 542C et une deuxième électrode 544C ;
le troisième photodétecteur 54D est constitué d'une couche active 540D comprise entre une première électrode 542D et une deuxième électrode 544D ;
le deuxième photodétecteur 56B est constitué d'une couche active 560B comprise entre une première électrode 562B et une deuxième électrode 564B ; et
le troisième photodétecteur 56D est constitué d'une couche active 560D comprise entre une première électrode 562D et une deuxième électrode 564D.

De la même façon, dans le capteur d'images 5 :

le premier photodétecteur 50A est constitué d'une couche active 500A (non visible en figure 1) comprise entre une première électrode 502A (non visible en figure 1) et une deuxième électrode 504A (non visible en figure 1) ;
le troisième photodétecteur 50D est constitué d'une couche active 500D (non visible en figure 1) comprise entre une première électrode 502D (non visible en figure 1) et une deuxième électrode 504D (non visible en figure 1) ;
le premier photodétecteur 52A est constitué d'une couche active 520A (non visible en figure 1) comprise entre une première électrode 522A (non visible en figure 1) et une deuxième électrode 524A (non visible en figure 1) ;
le deuxième photodétecteur 52B est constitué d'une couche active 520B (non visible en figure 1) comprise entre une première électrode 522B (non visible en figure 1) et une deuxième électrode 524B (non visible en figure 1) ;
le troisième photodétecteur 52C est constitué d'une couche active 520C (non visible en figure 1) comprise entre une première électrode 522C (non visible en figure 1) et une deuxième électrode 524C (non visible en figure 1) ;
le troisième photodétecteur 52D est constitué d'une couche active 520D (non visible en figure 1) comprise entre une première électrode 522D (non visible en figure 1) et une deuxième électrode 524D (non visible en figure 1) ;
le premier photodétecteur 54A est constitué d'une couche active 540A (non visible en figure 1) comprise entre une première électrode 542A (non visible en figure 1) et une deuxième électrode 544A (non visible en figure 1) ;
le premier photodétecteur 56A est constitué d'une couche active 560A (non visible en figure 1) comprise entre une première électrode 562A (non visible en figure 1) et une deuxième électrode 564A (non visible en figure 1) ; et

le troisième photodétecteur 56C est constitué d'une couche active 560C (non visible en figure 1) comprise entre une première électrode 562C (non visible en figure 1) et une deuxième électrode 564C (non visible en figure 1).

Dans la suite de la description, les premières électrodes seront également désignées par l'expression « électrodes inférieures » tandis que les deuxièmes électrodes seront également désignées par l'expression « électrodes supérieures ».

Selon un mode de réalisation, l'électrode supérieure de chaque photodétecteur organique constitue une électrode d'anode tandis que l'électrode inférieure de chaque photodétecteur organique constitue une électrode de cathode.

L'électrode inférieure de chaque photodétecteur de chaque pixel du capteur d'images 5 est individuellement reliée, de préférence connectée, à un circuit de lecture (non représenté) du support CMOS 8. Chaque photodétecteur du capteur d'images 5 est par conséquent adressé de façon individuelle par son électrode inférieure. Ainsi, dans le capteur d'images 5, chaque photodétecteur possède une électrode inférieure distincte des électrodes inférieures de tous les autres photodétecteurs. En d'autres termes, chaque photodétecteur d'un pixel possède une électrode inférieure distincte :

de l'autre photodétecteur du même pixel ; et
des autres photodétecteurs des autres pixels.

Toujours dans le capteur d'images 5 :

tous les premiers photodétecteurs possèdent une première électrode supérieure commune ;
tous les deuxièmes photodétecteurs possèdent une deuxième électrode supérieure commune, distincte de la première électrode supérieure commune aux premiers photodétecteurs ; et
tous les troisièmes photodétecteurs possèdent une troisième électrode supérieure commune, distincte de la première électrode supérieure commune aux premiers photodétecteurs et de la deuxième électrode commune aux deuxièmes photodétecteurs.

Dans le capteur d'images 5, chaque pixel comporte une lentille 58, également appelée microlentille 58 en raison de ses dimensions. Ainsi, dans la représentation simplifiée de la figure 1 les pixels 50, 52, 54 et 56 comportent chacun une lentille 58. Chaque lentille 58 recouvre ainsi totalement les premier, deuxième et troisièmes photodétecteurs de chaque pixel du capteur d'images 5. Plus précisément, la lentille 58 recouvre physiquement les électrodes supérieures des premier, deuxième et troisièmes photodétecteurs du pixel.

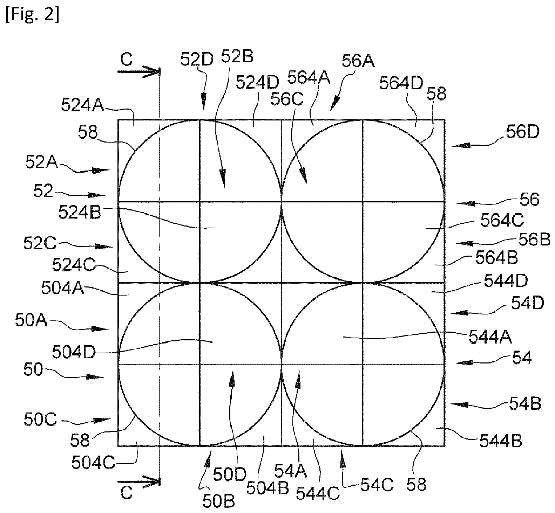

La figure 2 est une vue de dessus, schématique et partielle, du capteur d'images de la figure 1.

Dans cette vue de dessus, on a représenté les premiers, deuxièmes et troisièmes photodétecteurs par des carrés et les microlentilles par des cercles. Plus précisément, en figure 2 :

une microlentille 58 recouvre les électrodes supérieures 504A, 504B, 504C et 504D des photodétecteurs 50A, 50B, 50C et 50D, respectivement, du pixel 50 ;
une microlentille 58 recouvre les électrodes supérieures 524A, 524B, 524C et 524D des photodétecteurs 52A, 52B, 52C et 52D, respectivement, du pixel 52 ;
une microlentille 58 recouvre les électrodes supérieures 544A, 544B, 544C et 544D des photodétecteurs 54A, 54B, 54C et 54D, respectivement, du pixel 54 ; et
une microlentille 58 recouvre les électrodes supérieures 564A, 564B, 564C et 564D des photodétecteurs 56A, 56B, 56C et 56D, respectivement, du pixel 56.

En pratique, grâce aux intervalles entre électrodes qui ressortiront de l'exposé des figures suivantes, on peut considérer que les lentilles 58 recouvrent totalement les électrodes respectives des pixels auxquels elles sont associées.

Dans le capteur d'images 5, vu de dessus en figure 2, les pixels sont sensiblement de forme carrée, de préférence de forme carrée. Tous les pixels du capteur d'images 5 présentent préférentiellement des dimensions identiques, aux dispersions de fabrication près.

Le carré formé par chaque pixel du capteur d'images 5, vu de dessus en figure 2, a un côté compris entre environ 0,8 $\mu$m et 10 $\mu$m, de préférence compris entre environ 0,8 $\mu$m et 5 $\mu$m, encore plus préférentiellement compris entre 0,8 $\mu$m et 3 $\mu$m.

Les premier, deuxième et troisièmes photodétecteurs appartenant à un même pixel (par exemple, le premier photodétecteur 50A, le deuxième photodétecteur 50B et les troisièmes photodétecteurs 50C, 50D du premier pixel 50) sont de forme carrée. Ces photodétecteurs possèdent sensiblement les mêmes dimensions et s'inscrivent conjointement dans le carré formé par le pixel auquel ils appartiennent.

Le carré formé par chaque photodétecteur de chaque pixel du capteur d'images 5 a un côté sensiblement égal à la moitié du côté du carré formé par chaque pixel. Des espaces sont toutefois ménagés entre les premier, deuxième et troisièmes photodétecteurs de chaque pixel, de telle sorte que leurs électrodes inférieures respectives sont disjointes.

Dans le capteur d'images 5, chaque microlentille 58 présente, vue de dessus en figure 2, un diamètre sensiblement égal, de préférence égal, au côté du carré formé par le pixel auquel elle appartient. Dans le présent mode de réalisation, chaque pixel comporte une microlentille 58. Chaque microlentille 58 du capteur d'images 5 est, de préférence, centrée par rapport au carré formé par les photodétecteurs qu'elle recouvre.

À titre de variante, chaque microlentille 58 peut être remplacée par un autre type d'élément optique de taille micrométrique, notamment une lentille de Fresnel de taille micrométrique, une lentille à gradient d'indice de taille micrométrique ou un réseau de diffraction de taille micrométrique. Les microlentilles 58 sont des lentilles convergentes ayant chacune une distance focale f comprise entre 1 μm et 100 μm, de préférence entre 1 μm et 10 μm. Selon un mode de réalisation, toutes les microlentilles 58 sont sensiblement identiques.

Les microlentilles 58 peuvent être réalisées en silice, en polyméthacrylate de méthyle (PMMA), en une résine photosensible positive, en polyéthylène téréphtalate (PET), en polyéthylène naphtalate (PEN), en copolymère cyclo-oléfine (COP), en polydiméthylsiloxane (PDMS)/silicone, ou en résine époxy. Les microlentilles 58 peuvent être formées par fluage de blocs d'une résine photosensible. Les microlentilles 58 peuvent en outre être formées par moulage sur une couche de PET, PEN, COP, PDMS/silicone ou résine époxy.

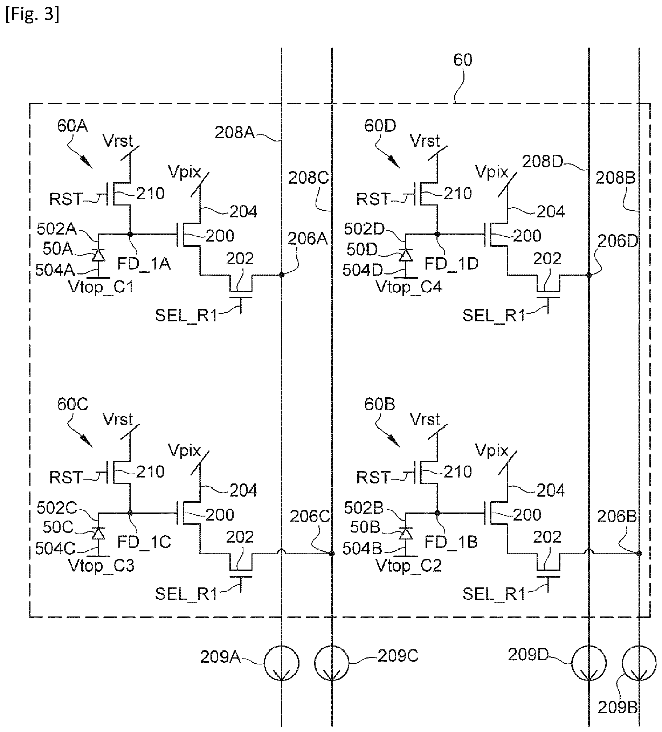

La figure 3 est un schéma électrique d'un mode de réalisation de circuits de lecture d'un pixel du capteur d'images 5 des figures 1 et 2.

Pour simplifier, on ne s'intéresse en figure 3 qu'aux circuits de lecture associés à un seul pixel du capteur d'images 5, par exemple le pixel 50 du capteur d'images 5. Dans cet exemple, chaque photodétecteur est associé à un circuit de lecture. Plus précisément, en figure 3 :

le premier photodétecteur 50A du pixel 50 est associé à un premier circuit de lecture 60A ;
le deuxième photodétecteur 50B du pixel 50 est associé à un deuxième circuit de lecture 60B ;
le troisième photodétecteur 50C du pixel 50 est associé à un troisième circuit de lecture 60C ; et
le troisième photodétecteur 50D du pixel 50 est associé à un quatrième circuit de lecture 60D.

Le premier circuit de lecture 60A du premier photodétecteur 50A du pixel 50, le deuxième circuit de lecture 60B du deuxième photodétecteur 50B du pixel 50, le troisième circuit de lecture 60C du troisième photodétecteur 50C du pixel 50 et le quatrième circuit de lecture 60D du troisième photodétecteur 50D forment conjointement un circuit de lecture 60 du pixel 50.

Selon ce mode de réalisation, chaque circuit de lecture 60A, 60B, 60C, 60D comprend trois transistors MOS. Un tel circuit est couramment désigné, avec son photodétecteur, par l'expression « capteur 3T ». En particulier, dans l'exemple de la figure 3 :

le circuit de lecture 60A, associé au premier photodétecteur 50A, comporte un transistor MOS en montage suiveur 200, en série avec un transistor MOS de sélection 202, entre deux bornes 204 et 206A ;
le circuit de lecture 60B, associé au deuxième photodétecteur 50B, comporte un transistor MOS en montage suiveur 200, en série avec un transistor MOS de sélection 202, entre deux bornes 204 et 206B ;
le circuit de lecture 60C, associé au troisième photodétecteur 50C, comporte un transistor MOS en montage suiveur 200, en série avec un transistor MOS de sélection 202, entre deux bornes 204 et 206C ; et
le circuit de lecture 60D, associé au troisième photodétecteur 50D, comporte un transistor MOS en montage suiveur 200, en série avec un transistor MOS de sélection 202, entre deux bornes 204 et 206D.

Chaque borne 204 est reliée à une source d'un potentiel de référence haut, noté Vpix, dans le cas où les transistors des circuits de lecture sont des transistors MOS à canal N. Chaque borne 204 est reliée à une source d'un potentiel de référence bas, par exemple la masse, dans le cas où les transistors des circuits de lecture sont des transistors MOS à canal P.

La borne 206A est reliée à une première piste conductrice 208A. La première piste conductrice 208A peut être reliée à tous les premiers photodétecteurs des pixels d'une même colonne. La première piste conductrice 208A est, de préférence, reliée à tous les premiers photodétecteurs du capteur d'images 5.

De façon analogue, la borne 206B est reliée à une deuxième piste conductrice 208B. La deuxième piste conductrice 208B peut être reliée à tous les deuxièmes photodétecteurs des pixels d'une même colonne. La deuxième piste conductrice 208B est, de préférence, reliée à tous les deuxièmes photodétecteurs du capteur d'images 5. La deuxième piste conductrice 208B est, de préférence, distincte de la première piste conductrice 208A.

De façon analogue, la borne 206C est reliée à une troisième piste conductrice 208C et la borne 206D est reliée à une quatrième piste conductrice 208D.

Selon un mode de réalisation préféré, la troisième piste conductrice 208C et la quatrième piste conductrice 208D sont connectées entre elles. Les pistes conductrices 208C, 208D peuvent être reliées à tous les troisièmes photodétecteurs des pixels d'une même colonne. Les pistes conductrices 208C, 208D sont, de préférence, reliées à tous les troisièmes photodétecteurs du capteur d'images 5. La troisième piste conductrice 208C et la quatrième piste conductrice 208D sont, de préférence, distinctes de la première piste conductrice 208A et de la deuxième piste conductrice 208B.

Dans l'exemple de la figure 3 :

la première piste conductrice 208A est reliée, de préférence connectée, à une première source de courant 209A ;

la deuxième piste conductrice 208B est reliée, de préférence connectée, à une deuxième source de courant 209B ;

la troisième piste conductrice 208C est reliée, de préférence connectée, à une troisième source de courant 209C ;

la quatrième piste conductrice 208D est reliée, de préférence connectée, à une quatrième source de courant 209D.

Ces sources de courant 209A, 209B, 209C et 209D ne font pas partie du circuit de lecture 60 du pixel 50 du capteur d'images 5. En d'autres termes, les sources de courant 209A, 209B, 209C et 209D du capteur d'images 5 sont externes aux pixels et circuits de lecture. Selon le mode de réalisation préféré où la troisième piste conductrice 208C et la quatrième piste conductrice 208D sont interconnectées, ces pistes sont, de préférence, reliées à une unique source de courant 209C ou 209D.

La grille du transistor 202 est destinée à recevoir un signal, noté SEL_R1, de sélection du pixel 50 dans le cas du circuit de lecture 60 du pixel 50. On suppose que la grille du transistor 202 du circuit de lecture d'un autre pixel du capteur d'images 5, par exemple le circuit de lecture du pixel 52, est destinée à recevoir un autre signal, noté SEL_R2.

Dans l'exemple de la figure 3 :

la grille du transistor 200 associé au premier photodétecteur 50A du pixel 50 est reliée à un nœud FD_1A ;

la grille du transistor 200 associé au deuxième photodétecteur 50B du pixel 50 est reliée à un nœud FD_1B ;

la grille du transistor 200 associé au troisième photodétecteur 50C du pixel 50 est reliée à un nœud FD_1C ; et

la grille du transistor 200 associé au troisième photodétecteur 50D du pixel 50 est reliée à un nœud FD_1D.

Chaque nœud FD_1A, FD_1B, FD_1C, FD_1D est relié, par un transistor MOS 210 de réinitialisation, à une borne d'application d'un potentiel Vrst de réinitialisation, ce potentiel pouvant être identique au potentiel Vpix. La grille du transistor 210 est destinée à recevoir un signal RST de commande de réinitialisation du photodétecteur, permettant notamment de réinitialiser le nœud FD_1A, FD_1B, FD_1C ou FD_1D sensiblement au potentiel Vrst.

Dans l'exemple de la figure 3 :

le nœud FD_1A est connecté à l'électrode de cathode 502A du premier photodétecteur 50A du pixel 50 ;

le nœud FD_1B est connecté à l'électrode de cathode 502B du deuxième photodétecteur 50B du pixel 50 ;

le nœud FD_1C est connecté à l'électrode de cathode 502C du troisième photodétecteur 50C du pixel 50 ; et

le nœud FD_1D est connecté à l'électrode de cathode 502D du troisième photodétecteur 50D du pixel 50.

Toujours dans l'exemple de la figure 3 :

l'électrode d'anode 504A du premier photodétecteur 50A du pixel 50 est reliée à une source d'un potentiel de référence Vtop_C1 ;

l'électrode d'anode 504B du deuxième photodétecteur 50B du pixel 50 est reliée à une source d'un potentiel de référence Vtop_C2 ;

l'électrode d'anode 504C du troisième photodétecteur 50C du pixel 50 est reliée à une source du potentiel de référence Vtop_C3 ; et

l'électrode d'anode 504D du troisième photodétecteur 50D du pixel 50 est reliée à une source du potentiel de référence Vtop_C4.

Dans le capteur d'images 5, le potentiel Vtop_C1 est appliqué sur la première électrode supérieure commune à tous les premiers photodétecteurs. Le potentiel Vtop_C2 est, quant à lui, appliqué sur la deuxième électrode supérieure commune à tous les deuxièmes photodétecteurs. Le potentiel Vtop_C3 et le potentiel Vtop_C4 sont, de préférence, égaux et appliqués sur la troisième électrode supérieure commune à tous les troisièmes photodétecteurs.

Dans la suite de la description, on note arbitrairement :

VFD_1A la tension présente au nœud FD_1A ;

VFD_1B la tension présente au nœud FD_1B ;

VSEL_R1 la tension appliquée sur la grille des transistors 202 du pixel 50, c'est-à-dire la tension appliquée sur la grille du transistor 202 du premier photodétecteur 50A, sur la grille du transistor 202 du deuxième photodétecteur 50B et sur la grille des transistors 202 des troisièmes photodétecteur 50C, 50D ; et

VSEL_R2 la tension appliquée sur la grille des transistors 202 du pixel 52.

On considère dans la suite de la description que l'application de la tension VSEL_R1, respectivement VSEL_R2, est commandée par le signal binaire noté SEL_R1, respectivement SEL_R2.

On connaît d'autres types de capteurs, par exemple des capteurs dits « 4T ». L'utilisation de photodétecteurs organiques permet avantageusement d'économiser un transistor et d'utiliser un capteur 3T.

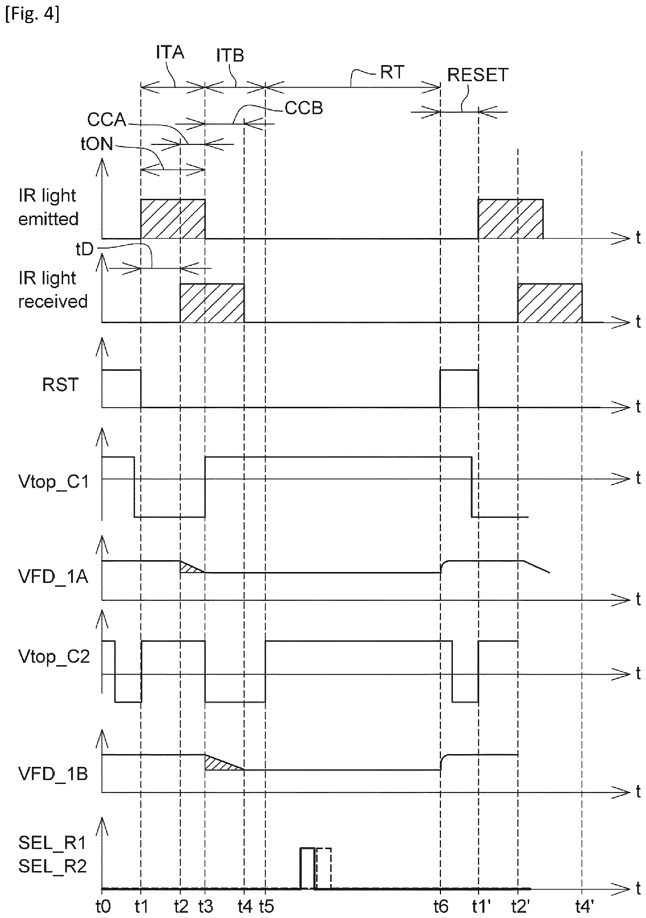

La figure 4 est un chronogramme de signaux d'un exemple de fonctionnement du capteur d'images 5 ayant les circuits de lecture de la figure 3.

Le chronogramme de la figure 4 correspond, plus particulièrement, à un exemple de fonctionnement du capteur d'images 5 en mode « temps de vol » (Time of Flight - ToF). Dans ce mode de fonctionnement, les pixels du capteur d'images 5 sont utilisés pour évaluer une distance les séparant d'un sujet (objet, scène, visage, etc.) placé ou situé en vis-à-vis de ce capteur d'images 5. Pour évaluer cette distance, on commence par émettre une impulsion lumineuse en direction du sujet avec un système émetteur associé non décrit dans ce texte. Cette impulsion lumineuse est généralement obtenue en illuminant brièvement le sujet par un rayonnement provenant d'une source, par exemple un rayonnement infrarouge proche issu d'une diode électroluminescente. Cette impulsion lumineuse est ensuite au moins partiellement réfléchie par le sujet, puis captée par le capteur d'images 5. On calcule ou on mesure alors une durée mise par l'impulsion lumineuse pour parcourir un aller-retour entre la source et le sujet. Le capteur d'images 5 étant avantageusement situé à proximité de la source, cette durée correspond environ au double de la durée mise par l'impulsion lumineuse pour parcourir la distance séparant le sujet de ce capteur d'images 5.

Le chronogramme de la figure 4 illustre un exemple d'évolution des signaux binaires RST et SEL_R1 ainsi que des potentiels Vtop_C1, Vtop_C2, VFD_1A et VFD_1B des premier et deuxième photodétecteurs d'un même pixel du capteur d'images 5, par exemple le premier photodétecteur 50A et le deuxième photodétecteur 50B du pixel 50. La figure 4 représente aussi, en trait pointillé, le signal binaire SEL_R2 d'un autre pixel du capteur d'images 5, par exemple le pixel 52. Le chronogramme de la figure 4 a été établi en considérant que les transistors MOS du circuit de lecture 60 du pixel 50 sont des transistors à canal N. Pour simplifier, on ne s'intéresse pas, dans ce chronogramme, au pilotage des troisièmes photodétecteurs 50C et 50D du pixel 50 du capteur d'images 5.

À un instant t0, le signal SEL_R1 est à l'état bas de sorte que les transistors 202 du pixel 50 soient bloqués. On entame alors une phase de réinitialisation. Dans ce but, le signal RST est maintenu à l'état haut de sorte que les transistors de réinitialisation 210 du pixel 50 soient passants. Les charges accumulées dans les photodiodes 50A et 50B sont alors évacuées vers la source du potentiel Vrst.

Le potentiel Vtop_C1 est, toujours à l'instant t0, à un niveau haut. Ce niveau haut correspond à une polarisation du premier photodétecteur 50A sous une tension supérieure à une tension résultant de l'application d'un potentiel appelé « potentiel intrinsèque » (built-in potential). Ce potentiel intrinsèque équivaut à une différence entre un travail de sortie de l'anode et un travail de sortie de la cathode. Lorsque le potentiel Vtop_C1 est au niveau haut, le premier photodétecteur 50A n'intègre pas de charges.

Avant un instant t1, postérieur à l'instant t0, le potentiel Vtop_C1 est mis à un niveau bas. Ce niveau bas correspond à une polarisation du premier photodétecteur 50A sous une tension négative, c'est-à-dire inférieure à 0 V. Cela permet ainsi au premier photodétecteur 50A d'intégrer des charges photogénérées. Ce qui a été décrit précédemment en relation avec la polarisation du premier photodétecteur 50A par le potentiel Vtop_C1 se transpose à l'explication du fonctionnement de la polarisation du deuxième photodétecteur 50B par le potentiel Vtop_C2.

À l'instant t1, on commence à émettre une première impulsion lumineuse infrarouge (IR light emitted) vers une scène comprenant un ou des objets dont on souhaite mesurer l'éloignement, ce qui permet d'acquérir une carte de profondeur de la scène. Cette première impulsion lumineuse infrarouge est d'une durée notée tON. À cet instant t1, le signal RST est mis à l'état bas, de sorte que les transistors de réinitialisation 210 du pixel 50 soient bloqués, et le potentiel Vtop_C2 est mis à un niveau haut.

Le potentiel Vtop_C1 étant au niveau bas, on entame ainsi, à l'instant t1, une première phase d'intégration, notée ITA, dans le premier photodétecteur 50A du pixel 50 du capteur d'images 5. On désigne par phase d'intégration d'un pixel la phase pendant laquelle le pixel collecte des charges sous l'effet d'un rayonnement incident.

À un instant t2, postérieur à l'instant t1 et séparé de cet instant t1 par une durée notée tD, on commence à recevoir une deuxième impulsion lumineuse infrarouge (IR light received) issue de la réflexion de la première impulsion lumineuse infrarouge par un objet de la scène, ou par un point d'un objet, dont on souhaite mesurer l'éloignement par rapport au pixel 50. La durée tD est donc fonction de la distance de l'objet au capteur 5. On entame alors une première phase de collection de charges, notée CCA, dans le premier photodétecteur 50A. Cette première phase de collection de charges correspond à une période pendant laquelle des charges sont générées proportionnellement à l'intensité de la lumière incidente, c'est-à-dire proportionnellement à l'intensité lumineuse de la deuxième impulsion, dans le photodétecteur 50A. La première phase de collection de charges provoque une baisse du niveau du potentiel VFD_1A au nœud FD_1A du circuit de lecture 60A.

À un instant t3, dans cet exemple postérieur à l'instant t2 et séparé de l'instant t1 par la durée tON, la première impulsion de lumière infrarouge cesse d'être émise. Le potentiel Vtop_C1 est simultanément mis au niveau haut, marquant ainsi la fin de la première phase d'intégration, donc de la première phase de collection de charges.

Dans un même temps, le potentiel Vtop_C2 est mis à un niveau bas. On entame ainsi, à l'instant t3, une deuxième phase d'intégration, notée ITB, dans le deuxième photodétecteur 50B du pixel 50 du capteur d'images 5. Étant donné que le deuxième photodétecteur 50B reçoit de la lumière issue de la deuxième impulsion lumineuse, on débute, toujours à l'instant t3, une deuxième phase de collection de charges, notée CCB. La deuxième phase de collection de charges provoque une baisse du niveau du potentiel VFD_1B au nœud FD_1B du circuit de lecture 60B.

À un instant t4, postérieur à l'instant t3 et séparé de l'instant t2 par une durée sensiblement égale à tON, la deuxième impulsion lumineuse cesse d'être captée par le deuxième photodétecteur 50B du pixel 50. La deuxième phase de collection de charges s'achève donc à cet instant t4.

À un instant t5, postérieur à l'instant t4, le potentiel Vtop_C2 est mis au niveau haut. Cela marque ainsi la fin de la deuxième phase d'intégration.

Entre l'instant t5 et un instant t6, postérieur à l'instant t5, on effectue une phase de lecture, notée RT, pendant laquelle une mesure de la quantité de charges collectée par les photodiodes des pixels du capteur d'images 5 est réalisée. Pour ce faire, on vient par exemple lire de façon séquentielle les lignes de pixels du capteur d'images 5. Dans l'exemple de la figure 4, les signaux SEL_R1 et SEL_R2 sont successivement mis à l'état haut pour venir lire alternativement les pixels 50 et 52 du capteur d'images 5.

Depuis l'instant t6 et jusqu'à un instant t1', postérieur à l'instant t6, on entame une nouvelle phase de réinitialisation (RESET). Le signal RST est mis à l'état haut de sorte que les transistors de réinitialisation 210 du pixel 50 soient passants. Les charges accumulées dans les photodiodes 50A et 50B sont alors évacuées vers la source du potentiel Vrst.

On calcule la durée tD, qui sépare le début de la première impulsion lumineuse émise du début de la deuxième impulsion lumineuse reçue, à l'aide de la formule suivante :

[Math 1]

$$tD = \frac{tON \times \Delta VFD\_1B}{\Delta VFD\_1A + \Delta VFD\_1B}$$

Dans la formule ci-dessus, la grandeur notée ΔVFD_1A correspond à une chute du potentiel VFD_1A durant la phase d'intégration du premier photodétecteur 50A. De façon analogue, la grandeur notée ΔVFD_1B correspond à une chute du potentiel VFD_1B durant la phase d'intégration du deuxième photodétecteur 50B.

À l'instant t1', on débute une nouvelle évaluation de distance par l'émission d'une deuxième impulsion lumineuse. Cette nouvelle évaluation de distance comporte des instants t2' et t4' semblables aux instants t2 et t4, respectivement.

Le fonctionnement du capteur d'images 5 a été illustré ci-dessus en relation avec un exemple de fonctionnement en mode temps de vol, dans lequel les premier et deuxième photodétecteurs d'un même pixel sont pilotés de façon désynchronisée. Un avantage du capteur d'images 5 est qu'il peut également fonctionner dans d'autres modes, notamment des modes dans lesquels les premier et deuxième photodétecteurs d'un même pixel sont pilotés de façon synchronisée. Le capteur d'images 5 peut, par exemple, être piloté en mode obturateur global (global shutter), c'est-à-dire que ce capteur d'images 5 peut également mettre en œuvre un procédé d'acquisition d'images dans lequel les débuts et fins des phases d'intégration des premier et deuxième photodétecteurs sont simultanés.

Un avantage du capteur d'images 5 est donc de pouvoir fonctionner alternativement selon différents modes. Le capteur d'images 5 peut, par exemple, fonctionner alternativement en mode temps de vol et en mode d'imagerie à obturateur global.

Selon un mode de mise en œuvre, les circuits de lecture des premiers et deuxièmes photodétecteurs du capteur d'images 5 sont pilotés alternativement dans d'autres modes de fonctionnement, par exemple des modes où le capteur d'images 5 est adapté à fonctionner :

dans une partie du spectre infrarouge ;
en lumière structurée ;
en imagerie à grande gamme dynamique (High Dynamic Range - HDR), en faisant par exemple en sorte que, pour chaque pixel, la durée d'intégration du premier photodétecteur soit supérieure à celle du deuxième photodétecteur ; et/ou
avec suppression de fond.

Le capteur d'images 5 peut ainsi être utilisé pour effectuer différents types d'images sans perte de résolution, car les différents modes d'imagerie pouvant être mis en œuvre par ce capteur d'images 5 exploitent un même nombre de pixels. L'utilisation du capteur d'images 5, capable d'intégrer plusieurs fonctionnalités dans une même matrice de pixels et de circuits de lecture, permet notamment de répondre aux contraintes actuelles de miniaturisation des dispositifs électroniques, par exemple des contraintes de conception et de fabrication de téléphones intelligents (smartphones).

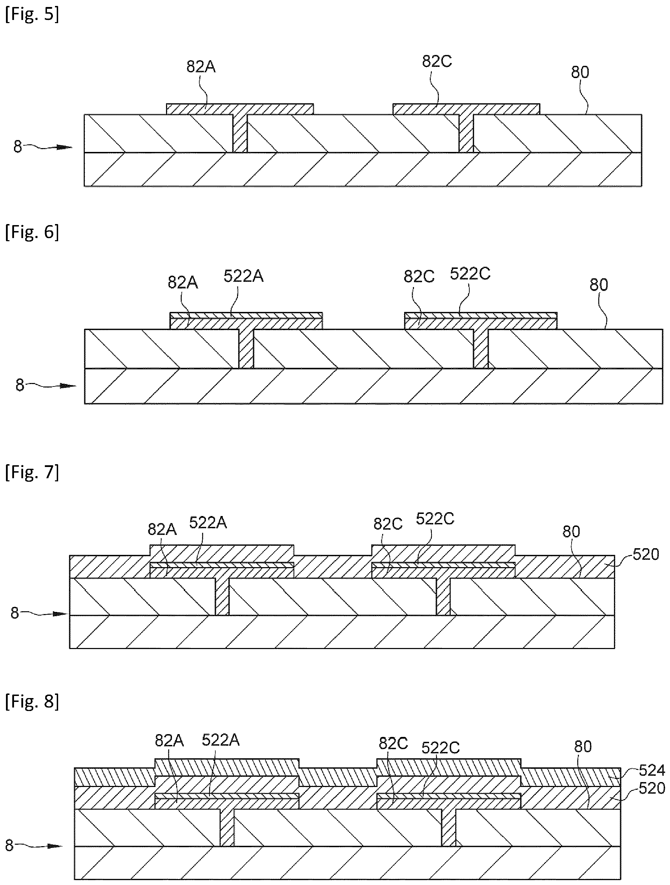

Les figures 5 à 16 ci-dessous illustrent des étapes successives d'un mode de mise en œuvre d'un procédé de réalisation du capteur d'images 5 des figures 1 et 2. Pour simplifier, ce qui est exposé ci-dessous en relation avec les figures 5 à 16 illustre la réalisation d'une partie d'un pixel du capteur d'images 5, par exemple le premier photodétecteur 52A et le troisième photodétecteur 52C du pixel 52 du capteur d'images 5. Néanmoins, il est entendu que ce procédé peut être étendu à la réalisation d'un nombre quelconque de photodétecteurs et de pixels d'un capteur d'images semblable au capteur d'images 5.

La figure 5 est une vue en coupe, schématique et partielle, d'une étape d'un mode de mise en œuvre d'un procédé de réalisation du capteur d'images 5 des figures 1 et 2.

Selon ce mode de mise en œuvre, on commence par prévoir le support CMOS 8 comportant notamment les circuits de lecture (non représentés) du pixel 52. Ce support CMOS 8 comporte en outre, en surface supérieure 80, des éléments de reprise de contact 82A et 82C. Ces éléments de reprise de contact 82A et 82C présentent, vus en coupe en figure 5, une forme de « T » dont :

une partie horizontale s'étend en surface supérieure 80 du support CMOS 8 ; et
une partie verticale s'étend vers le bas depuis la surface supérieure 80 du support CMOS 8 pour venir contacter des niveaux de métallisation inférieurs (non représentés) du support CMOS 8 reliés ou connectés aux circuits de lecture (non représentés).

Les éléments de reprise de contact 82A et 82C sont par exemple réalisés à partir de pistes conductrices formées en surface supérieure 80 du support CMOS 8 (parties horizontales des éléments de reprise de contact 82A et 82C) et de vias conducteurs (parties verticales des éléments de reprise de contact 82A et 82C) contactant ces pistes conductrices. Les pistes conductrices et les vias conducteurs peuvent être en un matériau métallique, par exemple l'argent (Ag), l'aluminium (Al), l'or (Au), le cuivre (Cu), le nickel (Ni), le titane (Ti) et le chrome (Cr), ou en nitrure de titane (TiN). Les pistes conductrices et les vias conducteurs peuvent avoir une structure monocouche ou multicouche. Dans le cas où les pistes conductrices possèdent une structure multicouche, ces pistes conductrices peuvent être constituées d'un empilement de couches conductrices séparées par des couches isolantes. Les vias traversent alors ces couches isolantes. Les couches conductrices peuvent être en un matériau métallique de la liste ci-dessus et les couches isolantes peuvent être en nitrure de silicium (SiN) ou en oxyde de silicium ($SiO_2$).

Lors de cette même étape, on procède à un nettoyage du support CMOS 8 afin de retirer d'éventuelles impuretés se trouvant à sa surface 80. Ce nettoyage s'effectue, par exemple, par plasma. Le nettoyage permet ainsi d'obtenir une propreté satisfaisante du support CMOS 8 avant d'effectuer une série de dépôts successifs, détaillés en relation avec les figures ci-dessous.

Dans la suite de la description, le mode de mise en œuvre du procédé décrit en relation avec les figures 6 à 16 consiste exclusivement à réaliser des opérations au-dessus de la surface supérieure 80 du support CMOS 8. Le support CMOS 8 des figures 6 à 16 est donc, de préférence, identique au support CMOS 8 tel qu'exposé en relation avec la figure 5 pendant tout le procédé. Pour simplifier, le support CMOS 8 ne sera donc pas à nouveau détaillé dans les figures ci-dessous.

La figure 6 est une vue en coupe, schématique et partielle, d'une autre étape du mode de mise en œuvre du procédé de réalisation du capteur d'images 5 des figures 1 et 2 à partir de la structure telle que décrite en relation avec la figure 5.

Au cours de cette étape, on procède à un dépôt, en surface des éléments de reprise de contact 52A et 52C, d'un matériau injecteur d'électrons. On dépose, de préférence, un matériau s'attachant ou se liant sélectivement en surface des éléments de reprise de contact 52A et 52C pour constituer une monocouche auto-assemblée (Self-Assembled Monolayer - SAM). Ce dépôt recouvre ainsi préférentiellement ou uniquement les surfaces supérieures libres des éléments de reprise de contact 52A et 52C. On forme donc, comme illustré en figure 6 :

l'électrode inférieure 522A du premier photodétecteur organique 52A du pixel 52 ; et
l'électrode inférieure 522C du troisième photodétecteur organique 52C du pixel 52.

En variante, on procède à un dépôt pleine plaque d'un matériau injecteur d'électrons possédant une conductivité latérale suffisamment faible pour ne pas créer de chemins de conduction entre deux éléments de reprise de contact voisins.

Les électrodes inférieures 522A et 522C constituent des couches d'injection d'électrons (Electron Injection Layer - EIL) des photodétecteurs 52A et 52C, respectivement. Ces électrodes inférieures 522A et 522C sont également appelées cathodes des photodétecteurs 52A et 52C. Les électrodes inférieures 522A et 522C sont, de préférence, réalisées par enduction centrifuge à la tournette (spin coating) ou par enduction par trempage (dip coating).

Le matériau composant les électrodes inférieures 522A et 522C est choisi parmi le groupe comprenant :

un métal ou un alliage métallique, par exemple de l'argent (Ag), de l'aluminium (Al), du plomb (Pb), du palladium (Pd), de l'or (Au), du cuivre (Cu), du nickel (Ni), du tungstène (W), du molybdène (Mo), du titane (Ti) ou du chrome (Cr) ou un alliage de magnésium et d'argent (MgAg) ;
un oxyde conducteur transparent (Transparent Conductive Oxide - TCO), notamment de l'oxyde d'indium dopé à l'étain (Indium Tin Oxide - ITO), un oxyde de zinc et d'aluminium (Aluminium Zinc Oxide - AZO), un oxyde de gallium et de zinc (Gallium Zinc Oxide - GZO), un multicouche ITO/Ag/ITO, un multicouche ITO/Mo/ITO, un multicouche AZO/Ag/AZO ou un multicouche ZnO/Ag/ZnO ;
un polymère de polyéthylèneimine (PEI) ou un polymère de polyéthylèneimine éthoxylée (PEIE), propoxylée et/ou butoxylée ;
des nanofils de carbone, d'argent et/ou de cuivre ;
du graphène ; et
un mélange d'au moins deux de ces matériaux.

Les électrodes inférieures 522A et 522C peuvent avoir une structure monocouche ou multicouche.

La figure 7 est une vue en coupe, schématique et partielle, d'encore une autre étape du mode de mise en œuvre du procédé de réalisation du capteur d'images 5 des figures 1 et 2 à partir de la structure telle que décrite en relation avec la figure 6.

Au cours de cette étape, on procède à un dépôt non sélectif d'une première couche 520 du côté de la surface supérieure 80 du support CMOS 8. Ce dépôt est qualifié de dépôt « pleine plaque » car il recouvre la totalité de la surface supérieure 80 du support CMOS 8 ainsi que les surfaces libres des éléments de reprise de contact 52A, 52C et des électrodes inférieures 522A et 522C. Le dépôt de la première couche 520 est, de préférence, réalisé par enduction centrifuge à la tournette.

Selon ce mode de mise en œuvre, la première couche 520 est destinée à former les futures couches actives 520A et 520C des photodétecteurs 52A et 52C du pixel 52. Les couches actives 520A et 520C des photodétecteurs 52A et 52C du pixel 52 possèdent, de préférence, une composition et une épaisseur identiques à celles de la première couche 520.

La première couche 520 peut comprendre des petites molécules, des oligomères ou des polymères. Il peut s'agir de matériaux organiques ou inorganiques, notamment comprenant des boîtes quantiques. La première couche 520 peut comprendre un matériau semiconducteur ambipolaire, ou un mélange d'un matériau semiconducteur de type N et d'un matériau semiconducteur de type P, par exemple sous forme de couches superposées ou d'un mélange intime à l'échelle nanométrique de façon à former une hétérojonction en volume. L'épaisseur de la première couche 520 peut être comprise entre 50 nm et 2 $\mu$m, par exemple de l'ordre de 300 nm.

Des exemples de polymères semiconducteurs de type P adaptés à la réalisation de la couche 520 sont :

le poly(3-hexylthiophène) (P3HT) ;
le poly[N-9'-heptadécanyl-2,7-carbazole-alt-5,5-(4,7-di-2-thiényl-2',1',3'-benzothiadiazole)] (PCDTBT) ;
le poly[(4,8-bis-(2-éthylhexyloxy)-benzo[1,2-b;4,5-b'] dithiophène)-2,6-diyl-alt-(4-(2-éthylhexanoyl)-thieno[3,4-b] thiophène))-2,6-diyl] (PBDTTT-C) ;
le poly[2-méthoxy-5-(2-éthyl-hexyloxy)-1,4-phénylène-vinylène] (MEH-PPV) ; et
le poly[2,6-(4,4-bis-(2-éthylhexyl)-4H-cyclopenta [2,1-*b*;3,4-*b*'] dithiophène)-*alt*-4,7(2,1,3-benzothiadiazole)] (PCPDTBT).

Des exemples de matériaux semiconducteurs de type N adaptés à la réalisation de la couche 520 sont les fullerènes, notamment le C60, le [6,6]-phényl-$C_{61}$-butanoate de méthyle ([60]PCBM), le [6,6]-phényl-$C_{71}$-butanoate de méthyle ([70]PCBM), le pérylène diimide, l'oxyde de zinc (ZnO) ou des nanocristaux permettant la formation de boîtes quantiques (quantum dots).

La figure 8 est une vue en coupe, schématique et partielle, d'encore une autre étape du mode de mise en œuvre du procédé de réalisation du capteur d'images 5 des figures 1 et 2 à partir de la structure telle que décrite en relation avec la figure 7.

Au cours de cette étape, on procède à un dépôt non sélectif d'une deuxième couche 524 du côté de la surface supérieure 80 du support CMOS 8. Ce dépôt est qualifié de dépôt « pleine plaque » car il recouvre la totalité de la surface supérieure de la première couche 520. Le dépôt de la deuxième couche 524 est, de préférence, effectué par enduction centrifuge à la tournette.

Selon ce mode de mise en œuvre, la deuxième couche 524 est destinée à former les futures électrodes supérieures 524A et 524C des photodétecteurs 52A et 52C du pixel 52. Les électrodes supérieures 524A et 524C des photodétecteurs 52A et 52C du pixel 52 possèdent, de préférence, une composition et une épaisseur identiques à celles de la deuxième couche 524.

La deuxième couche 524 est au moins partiellement transparente au rayonnement lumineux qu'elle reçoit. La deuxième couche 524 peut être en un matériau conducteur et transparent, par exemple en oxyde conducteur et transparent (Transparent Conductive Oxide - TCO), en nanotubes de carbone, en graphène, en un polymère conducteur, en un métal, ou en un mélange ou un alliage d'au moins deux de ces composés. La deuxième couche 524 peut avoir une structure monocouche ou multicouche.

Des exemples de TCO adaptés à la réalisation de la deuxième couche 524 sont l'oxyde d'indium-étain (Indium Tin Oxide - ITO), l'oxyde d'aluminium-zinc (Aluminium Zinc Oxide - AZO), l'oxyde de gallium-zinc (Gallium Zinc Oxide - GZO), le nitrure de titane (TiN), l'oxyde de molybdène ($MoO_3$) et l'oxyde de tungstène ($WO_3$). Un exemple de polymère conducteur adapté à la réalisation de la deuxième couche 524 est le polymère connu sous la dénomination PEDOT:PSS, qui est un mélange de poly(3,4)-éthylènedioxythiophène et de polystyrène sulfonate de sodium et la polyaniline, également appelé PAni. Des exemples de métaux adaptés à la réalisation de la deuxième couche 524 sont l'argent, l'aluminium, l'or, le cuivre, le nickel, le titane et le chrome. Un exemple de structure multicouche adaptée à la réalisation de la deuxième couche 524 est une structure multicouche d'AZO et d'argent de type AZO/Ag/AZO.

L'épaisseur de la deuxième couche 524 peut être comprise entre 10 nm et 5 $\mu$m, par exemple de l'ordre de 60 nm. Dans le cas où la deuxième couche 524 est métallique, l'épaisseur de cette deuxième couche 524 est inférieure ou égale à 20 nm, de préférence inférieure ou égale à 10 nm.

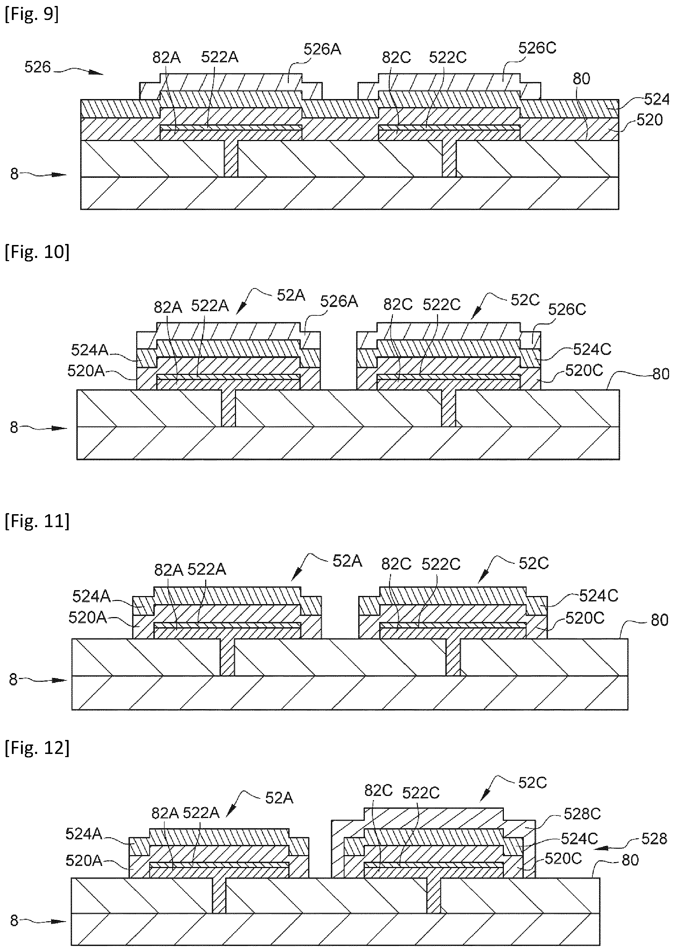

La figure 9 est une vue en coupe, schématique et partielle, d'encore une autre étape du mode de mise en œuvre du procédé de réalisation du capteur d'images 5 des figures 1 et 2 à partir de la structure telle que décrite en relation avec la figure 8.

Au cours de cette étape, on protège les futurs photodétecteurs 52A et 52C en vue d'étapes ultérieures. Cette protection est, par exemple, réalisée par :

une première opération consistant à déposer, sur toute la surface supérieure de la deuxième couche 524, une troisième couche 526 (dont seules des parties 526A et 526C subsistent en fin d'étape et sont visibles), constituée d'une photorésine de photolithographie ;

une deuxième opération consistant à insoler, au travers d'un masque, cette troisième couche 526 de photorésine ; et

une troisième opération consistant à éliminer, par un solvant, des parties non insolées de la troisième couche 526 (dans le cas d'une troisième couche 526 constituée d'une photorésine négative) pour ne conserver, à l'emplacement de la première photodiode 52A, qu'une première partie 526A (insolée, toujours dans le cas d'une photorésine négative) de cette troisième couche 526 et pour ne conserver, à l'emplacement de la troisième photodiode 52C, qu'une deuxième partie 526C (insolée dans le cas d'une photorésine négative) de cette troisième couche 526. Dans le cas où la troisième couche 526 est réalisée à partir d'une photorésine positive, ce sont les parties insolées de cette troisième couche 526 qui sont retirées.

La figure 10 est une vue en coupe, schématique et partielle, d'encore une autre étape du mode de mise en œuvre du procédé de réalisation du capteur d'images 5 des figures 1 et 2 à partir de la structure telle que décrite en relation avec la figure 9.

Au cours de cette étape, on effectue une opération de gravure, par exemple par un procédé de gravure sèche (par exemple, une gravure plasma du type gravure ionique réactive (Reactive Ion Etching - RIE)), pour éliminer des zones non protégées de la deuxième couche 524 et de la première couche 520. On procède, de préférence, à une gravure anisotrope de sorte que cette gravure fasse préférentiellement (ou sélectivement, ou majoritairement) disparaître des zones horizontales de la deuxième couche 524 et de la première couche 520 par rapport à des zones verticales de ces couches 524, 520.

On élimine donc des parties des couches 520, 524 non recouvertes par la première partie 526A et par la deuxième partie 526C de la troisième couche 526 pour former, comme illustré en figure 10 :

la couche active 520A du premier photodétecteur 52A du pixel 52 ;
l'électrode supérieure 524A du premier photodétecteur 52A du pixel 52 ;
la couche active 520C du troisième photodétecteur 52C du pixel 52 ; et
l'électrode supérieure 524C du troisième photodétecteur 52C du pixel 52.

Les électrodes supérieures 524A et 524C constituent des couches d'injection de trous (Hole Injection Layer - HIL) des photodétecteurs 52A et 52C, respectivement. Ces électrodes supérieures 524A et 524C sont également appelées anodes des photodétecteurs 52A et 52C.

La figure 11 est une vue en coupe, schématique et partielle, d'encore une autre étape du mode de mise en œuvre du procédé de réalisation du capteur d'images 5 des figures 1 et 2 à partir de la structure telle que décrite en relation avec la figure 10.

Au cours de cette étape, on retire la première partie 526A et la deuxième partie 526C de la troisième couche 526. On libère ainsi :

la surface supérieure de l'électrode supérieure 524A du premier photodétecteur 52A du pixel 52 ; et
la surface supérieure de l'électrode supérieure 524C du troisième photodétecteur 52C du pixel 52.

La figure 12 est une vue en coupe, schématique et partielle, d'encore une autre étape du mode de mise en œuvre du procédé de réalisation du capteur d'images 5 des figures 1 et 2 à partir de la structure telle que décrite en relation avec la figure 11.

Au cours de cette étape, on protège le futur photodétecteur 52C par une encapsulation 528C. Cette encapsulation 528C est, par exemple, réalisée par :

une première opération consistant à déposer, sur toute la surface supérieure de la structure, une quatrième couche 528 (dont seule une partie 528C subsiste en fin d'étape et est visible), constituée d'un matériau diélectrique photoformable ou photomodélisable (photo-patternable dielectric) ;

une deuxième opération consistant à insoler, au travers d'un masque, cette quatrième couche 528 de diélectrique photostructurable ; et

une troisième opération consistant à éliminer, par un solvant, des parties non insolées de la quatrième couche 528 pour ne conserver, à l'emplacement de la troisième photodiode 52C, qu'une partie 528C (insolée) de cette quatrième couche 528. On recouvre ainsi totalement, par la partie 528C de la quatrième couche 528, les faces supérieures et latérales libres d'un empilement formé par la couche active 520C et l'électrode supérieure 524C du troisième photodétecteur 52C. Le matériau dont est constituée la quatrième couche 528 est alors, de préférence, une résine de polarité négative.

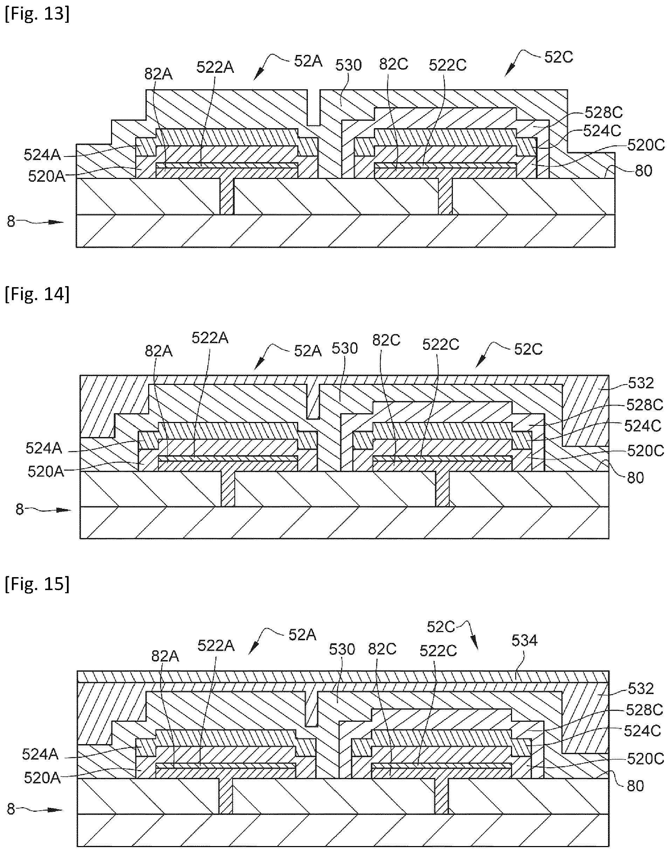

La figure 13 est une vue en coupe, schématique et partielle, d'encore une autre étape du mode de mise en œuvre du procédé de réalisation du capteur d'images 5 des figures 1 et 2 à partir de la structure telle que décrite en relation avec la figure 12.

Au cours de cette étape, on procède à un dépôt non sélectif d'une cinquième couche 530 du côté de la surface supérieure 80 du support CMOS 8 (dépôt « pleine plaque »). Selon ce mode de mise en œuvre, la cinquième couche 530 est destinée à prolonger l'électrode supérieure 524A du photodétecteur 52A du pixel 52.

Selon un mode de mise en œuvre, la cinquième couche 530 possède une composition similaire, de préférence identique, à celle de la deuxième couche 524 comme exposé en relation avec la figure 8. La cinquième couche 530 se comporte alors comme une couche de transport de trous (Hole Transport Layer - HTL), également appelée électrode d'accès.

Selon un autre mode de mise en œuvre, la cinquième couche 530 possède une composition différente de celle de la deuxième couche 524.

La figure 14 est une vue en coupe, schématique et partielle, d'encore une autre étape du mode de mise en œuvre du procédé de réalisation du capteur d'images 5 des figures 1 et 2 à partir de la structure telle que décrite en relation avec la figure 13.

Au cours de cette étape, on procède à un dépôt non sélectif d'une sixième couche 532 du côté de la surface supérieure 80 du support CMOS 8. Ce dépôt est qualifié de dépôt « pleine plaque » car il recouvre la totalité de la surface supérieure de la cinquième couche 530. Cette sixième couche 532 est, de préférence, une couche dite de « planarisation » permettant d'obtenir une structure présentant une surface supérieure plane avant encapsulation des photodétecteurs.

La sixième couche 532 de planarisation peut être constituée d'un matériau diélectrique à base de polymères. La couche 532 de planarisation peut alternativement contenir du nitrure de silicium (SiN) ou de l'oxyde de silicium ($SiO_2$), cette couche étant obtenue par pulvérisation (sputtering), par dépôt physique par phase vapeur (Physical Vapor Deposition - PVD) ou par dépôt chimique en phase vapeur assisté par plasma (Plasma-Enhanced Chemical Vapor Deposition - PECVD). En variante, la couche 532 est constituée d'une structure multicouche comportant des couches de nitrure de silicium et des couches d'oxyde de silicium empilées alternativement pour former, par exemple, une structure de type $SiN/SiO_2/SiN/SiO_2$.

La couche 532 de planarisation peut également être réalisée en polymère fluoré, notamment le polymère fluoré connu sous la dénomination commerciale « Cytop » de la société Bellex, en polyvinylpyrrolidone (PVP), en polyméthacrylate de méthyle (PMMA), en polystyrène (PS), en parylène, en polyimide (PI), en acrylonitrile butadiène styrène (ABS), en polydiméthylsiloxane (PDMS), en une résine de photolithographie, en résine époxy, en résine acrylate ou en un mélange d'au moins deux de ces composés.

La figure 15 est une vue en coupe, schématique et partielle, d'encore une autre étape du mode de mise en œuvre du procédé de réalisation du capteur d'images 5 des figures 1 et 2 à partir de la structure telle que décrite en relation avec la figure 14.

Au cours de cette étape, on dépose une septième couche 534 sur toute la structure du côté de la surface supérieure 80 du support CMOS 8. Cette septième couche 534 a pour but d'encapsuler les photodétecteurs organiques du capteur d'images 5. La septième couche 534 permet ainsi d'éviter la dégradation, du fait d'une exposition à l'eau ou à l'humidité contenue dans l'air ambiant, des matériaux organiques constitutifs des photodétecteurs du capteur d'images 5. Dans l'exemple de la figure 15, la septième couche 534 recouvre la totalité de la surface supérieure libre de la sixième couche de planarisation 532.

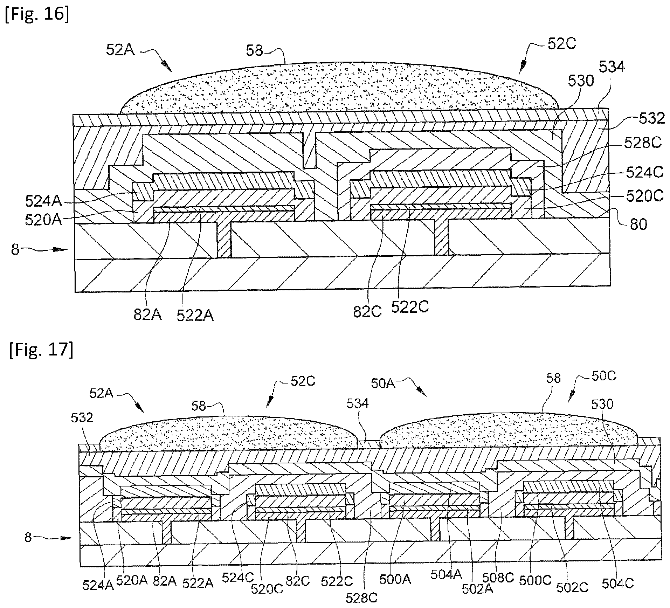

La figure 16 est une vue en coupe, schématique et partielle, d'encore une autre étape du mode de mise en œuvre du procédé de réalisation du capteur d'images 5 des figures 1 et 2 à partir de la structure telle que décrite en relation avec la figure 15.

Au cours de cette étape, on vient réaliser la microlentille 58 du pixel 52 à l'aplomb des photodétecteurs 52A, 52B, 52C et 52D (seuls les photodétecteurs 52A et 52C sont visibles en figure 16).

Comme exposé en relation avec la figure 2, les microlentilles 58 peuvent être réalisées en silice, en PMMA, en une résine photosensible positive, en PET, en PEN, en COP, en PDMS/silicone, ou en résine époxy. Les microlentilles 58 peuvent être formées par fluage de blocs d'une résine photosensible. Les microlentilles 58 peuvent en outre être formées par moulage sur une couche de PET, PEN, COP, PDMS/silicone ou résine époxy.

La figure 17 est une vue en coupe selon le plan CC (figure 2), schématique et partielle, du capteur d'images des figures 1 et 2.

En figure 17, seuls les photodétecteurs 52A et 52C du pixel 52 et les photodétecteurs 50A et 50C du pixel 50 du capteur d'images 5 ont été représentés. Ces pixels 50 et 52 appartiennent à une même colonne de pixels du capteur d'images 5. Dans l'exemple de la figure 17, les photodétecteurs 52A, 52C du pixel 52 et les photodétecteurs 50A, 50C du pixel 50 sont séparés les uns des autres. Ainsi, le long d'une même colonne du capteur d'images 5, chaque photodétecteur est isolé des photodétecteurs voisins.

Dans l'exemple de la figure 17 :

les couches actives 500A, 500C, 520A et 520C sont séparées les unes des autres ;
les électrodes inférieures 502A, 502C, 522A et 522C sont séparées les unes des autres ;
l'électrode supérieure 524A du premier photodétecteur 52A du pixel 52 et l'électrode supérieure 524C du troisième photodétecteur 52C du pixel 52 sont séparées par la partie 528C de la quatrième couche 528 de diélectrique ;
l'électrode supérieure 504A du premier photodétecteur 50A du pixel 50 et l'électrode supérieure 504C du troisième photodétecteur 50C du pixel 50 sont séparées par une partie 508C, analogue à la partie 528C, de la quatrième couche 528 de diélectrique ; et
l'électrode supérieure 524A du premier photodétecteur 52A du pixel 52 et l'électrode supérieure 504A du premier photodétecteur 50A du pixel 50 sont interconnectées par la cinquième couche 530.

En d'autres termes, tous les troisièmes photodétecteurs des pixels appartenant à une même colonne de pixels du capteur d'images 5 possèdent une électrode supérieure commune. Dans l'exemple de la figure 17, la cinquième couche 530 forme la troisième électrode supérieure commune aux troisièmes photodétecteurs 50C et 52C.

Selon un mode de mise en œuvre préféré, le dépôt de la cinquième couche 530 est réalisé de telle sorte que cette cinquième couche 530 constitue également une électrode supérieure commune de tous les troisièmes photodétecteurs des pixels d'une même colonne. Dans l'exemple de la figure 17, la cinquième couche 530 constitue alors la troisième électrode supérieure commune aux troisièmes photodétecteurs 50C, 50D du pixel 50 et aux troisièmes photodétecteurs 52C et 52D du pixel 52 comme exposé en relation avec la figure 1.

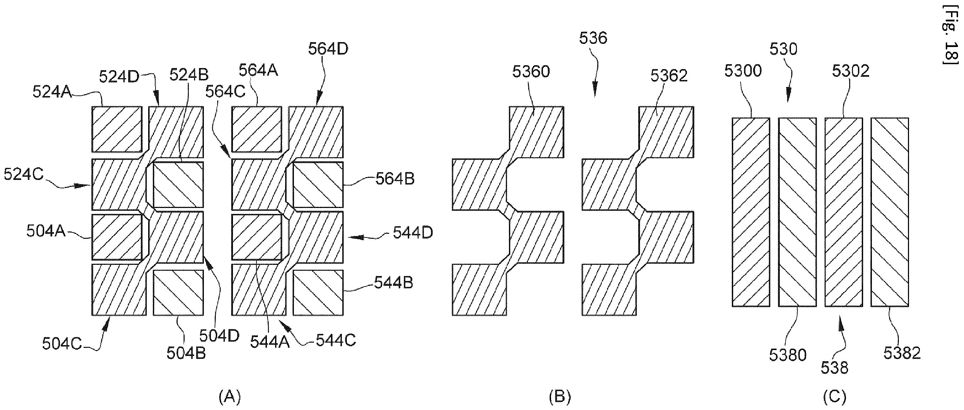

La figure 18 illustre, par des vues (A), (B) et (C), un mode de réalisation d'électrodes du capteur d'images 5 des figures 1 et 2. La vue (A) correspond ici à une superposition des vues (B) et (C).

La vue (A) représente :

les électrodes supérieures 504A, 524A, 544A et 564A des premiers photodétecteurs 50A, 52A, 54A et 56A du capteur d'images 5 ;
les électrodes supérieures 504B, 524B, 544B et 564B des deuxièmes photodétecteurs 50B, 52B, 54B et 56B du capteur d'images 5 ;
les électrodes supérieures 504C, 524C, 544C et 564C des troisièmes photodétecteurs 50C, 52C, 54C et 56C du capteur d'images 5 ; et
les électrodes supérieures 504D, 524D, 544D et 564D des troisièmes photodétecteurs 50D, 52D, 54D et 56D du capteur d'images 5.

Selon ce mode de réalisation, les électrodes supérieures des troisièmes photodétecteurs sont réalisées à partir d'une même couche 536, dont deux parties disjointes 5360 et 5362 sont représentées en vue (B). Ces parties 5360 et 5362 de la couche 536 forment chacune, dans cet exemple, une structure en « zig-zag ». La partie 5360 de la couche 536 constitue ainsi une électrode commune aux troisièmes photodétecteurs des pixels d'une première colonne du capteur d'images 5. De la même façon, la partie 5362 de la couche 536 constitue une électrode commune aux troisièmes photodétecteurs des pixels d'une deuxième colonne du capteur d'images 5.

La partie 5360 de la couche 536 relie ainsi les électrodes supérieures 504C, 504D, 524C et 524D des troisièmes photodétecteurs 50C, 50D, 52C et 52D des pixels 50 et 52 de la première colonne du capteur d'images 5. De façon analogue, la partie 5362 de la couche 536 relie les électrodes supérieures 544C, 544D, 564C et 564D des troisièmes photodétecteurs 54C, 54D, 56C et 56D des pixels 54 et 56 de la deuxième colonne du capteur d'images 5.

Les électrodes supérieures des premiers photodétecteurs sont réalisées à partir de la couche 530 (comme exposé en relation avec la figure 17), dont deux parties disjointes 5300 et 5302 sont représentées en vue (C). Ces parties 5300 et 5302 de la couche 530 forment chacune, dans cet exemple, une bande. La partie 5300 de la couche 530 constitue ainsi une électrode commune aux premiers photodétecteurs des pixels de la première colonne du capteur d'images 5. De la même façon, la partie 5302 de la couche 530 constitue une électrode commune aux premiers photodétecteurs des pixels de la deuxième colonne du capteur d'images 5.

La partie 5300 de la couche 530 relie ainsi les électrodes supérieures 504A et 524A des premiers photodétecteurs 50A et 52A des pixels 50 et 52 de la première colonne du capteur d'images 5. De façon analogue, la partie 5302 de la couche 530 relie les électrodes supérieures 544A et 564A des premiers photodétecteurs 54A et 56A des pixels 54 et 56 de la deuxième colonne du capteur d'images 5.

De façon analogue, les électrodes supérieures des deuxièmes photodétecteurs sont réalisées à partir d'une même couche 538, dont deux parties disjointes 5380 et 5382 sont représentées en vue (C). Ces parties 5380 et 5382 de la couche 538 forment chacune, dans cet exemple, une bande. La partie 5380 de la couche 538 constitue ainsi une électrode commune aux deuxièmes photodétecteurs des pixels de la première colonne du capteur d'images 5. De la même façon, la partie 5382 de la couche 538 constitue une électrode commune aux deuxièmes photodétecteurs des pixels de la deuxième colonne du capteur d'images 5.

La partie 5380 de la couche 538 relie ainsi les électrodes supérieures 504B et 524B des deuxièmes photodétecteurs 50B et 52B des pixels 50 et 52 de la première colonne du capteur d'images 5. De façon analogue, la partie 5382 de la couche 538 relie les électrodes supérieures 544B et 564B des deuxièmes photodétecteurs 54B et 56B des pixels 54 et 56 de la deuxième colonne du capteur d'images 5.

Les couches 530, 536 et 538 sont isolées les unes des autres. La couche 536 et les couches 530, 538 sont, de préférence, non coplanaires. Cela permet de faciliter l'isolation entre les différentes électrodes supérieures communes des photodétecteurs du capteur d'images 5.

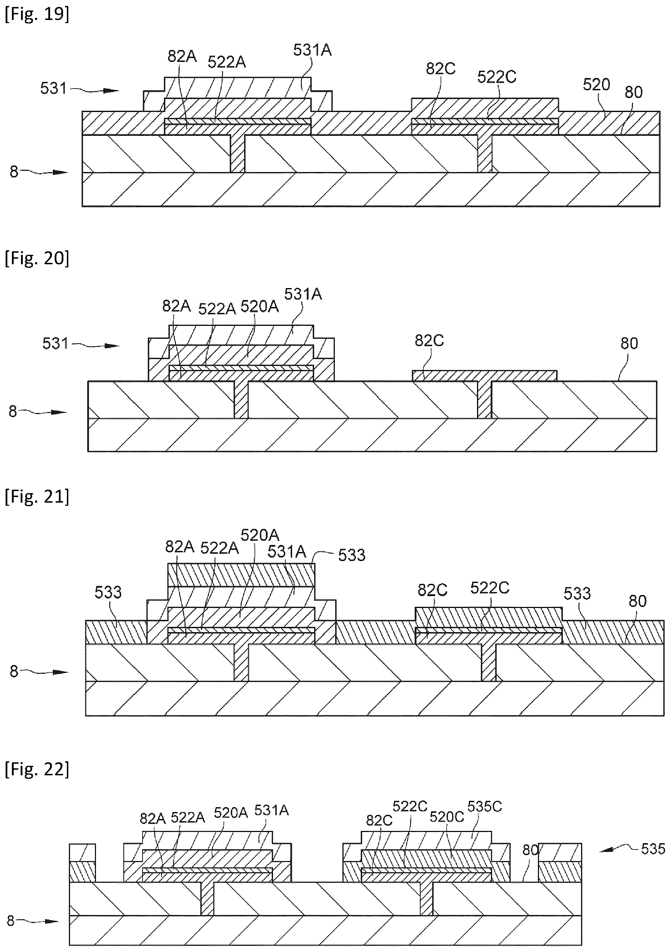

Les figures 19 à 24 ci-dessous illustrent des étapes successives d'un autre mode de mise en œuvre d'un procédé de réalisation du capteur d'images 5 des figures 1 et 2. Pour simplifier, ce qui est exposé ci-dessous en relation avec les figures 19 à 24 illustre la réalisation d'une partie d'un pixel du capteur d'images 5, par exemple le premier photodétecteur 52A et le troisième photodétecteur 52C du pixel 52 du capteur d'images 5. Néanmoins, il est entendu que ce procédé peut être étendu à la réalisation d'un nombre quelconque de photodétecteurs et de pixels d'un capteur d'images semblable au capteur d'images 5.

Les premières étapes de cet autre mode de mise en œuvre sont semblables aux étapes du mode de mise en œuvre précédemment décrit en relation avec les figures 5 à 7. Pour simplifier, ces étapes ne seront donc pas à nouveau détaillées ci-dessous.

La figure 19 est une vue en coupe, schématique et partielle, d'une étape d'un autre mode de mise en œuvre d'un procédé de réalisation du capteur d'images des figures 1 et 2 à partir de la structure telle que décrite en relation avec la figure 7.

Au cours de cette étape, on protège le futur photodétecteur 52A en vue d'étapes ultérieures. Cette protection est, par exemple, réalisée par :

une première opération consistant à déposer, sur toute la surface supérieure de la première couche 520, une huitième couche 531 (dont seule une partie 531A subsiste en fin d'étape et est visible), constituée d'une photorésine de photolithographie ;
une deuxième opération consistant à insoler, au travers d'un masque, cette huitième couche 531 de photorésine ; et
une troisième opération consistant à éliminer, par solvant, des parties insolées (dans le cas d'une huitième couche 531 constituée d'une photorésine positive) de la huitième couche 531 pour ne conserver, à l'emplacement de la première photodiode 52A, qu'une partie 531A (non insolée, toujours dans le cas d'une photorésine positive) de cette huitième couche 531.

La figure 20 est une vue en coupe, schématique et partielle, d'une autre étape de l'autre mode de mise en œuvre du procédé de réalisation du capteur d'images des figures 1 et 2 à partir de la structure telle que décrite en relation avec la figure 19.

Au cours de cette étape, on effectue une opération de gravure, par exemple par un procédé de gravure sèche (par exemple, une gravure plasma du type gravure ionique réactive), pour éliminer des zones non protégées de la première couche 520. On procède, de préférence, à une gravure anisotrope de sorte que cette gravure fasse préférentiellement (ou sélectivement, ou majoritairement) disparaître des zones horizontales de la première couche 520 par rapport à des zones verticales de cette couche 520.

On élimine donc des parties de la première couche 520 non recouvertes par la partie 531A de la huitième couche 531 ainsi que l'électrode inférieure 522C du futur troisième photodétecteur 52C. On forme ainsi, comme illustré en figure 20, la couche active 520A du premier photodétecteur 52A du pixel 52 et on met à nu l'élément de reprise de contact 82C du futur troisième photodétecteur 52C.

La figure 21 est une vue en coupe, schématique et partielle, d'encore une autre étape de l'autre mode de mise en œuvre du procédé de réalisation du capteur d'images 5 des figures 1 et 2 à partir de la structure telle que décrite en relation avec la figure 20.

Au cours de cette étape, on procède à un dépôt sur l'élément de reprise de contact 82C afin de reconstituer l'électrode inférieure 522C du futur troisième photodétecteur 52C. On dépose, de préférence, un matériau s'attachant ou se liant sélectivement en surface de l'élément de reprise de contact 52C pour constituer une monocouche auto-assemblée (Self-Assembled Monolayer - SAM). Ce dépôt recouvre ainsi préférentiellement ou uniquement la surface supérieure libre de l'élément de reprise de contact 52C.

On effectue ensuite un dépôt non sélectif d'une neuvième couche 533 du côté de la surface supérieure 80 du support CMOS 8. Selon ce mode de mise en œuvre, la neuvième couche 533 est destinée à former les futures couches actives 520C et 520D des troisièmes photodétecteurs 52C et 52D du pixel 52. Les couches actives 520C et 520D des photodétecteurs 52C et 52D du pixel 52 possèdent, de préférence, une composition identique à celle de la neuvième couche 533.

Selon un mode de mise en œuvre préféré, la composition de la neuvième couche 533 est différente de celle de la première couche 520. La première couche 520 possède, par exemple, une longueur d'onde d'absorption centrée sur la plage de longueurs d'ondes du domaine visible tandis que la neuvième couche 533 possède, par exemple, une longueur d'onde d'absorption d'environ 940 nm.

La figure 22 est une vue en coupe, schématique et partielle, d'encore une autre étape de l'autre mode de mise en œuvre du procédé de réalisation du capteur d'images 5 des figures 1 et 2 à partir de la structure telle que décrite en relation avec la figure 21.

Au cours de cette étape, on procède à une première opération consistant à déposer, du côté de la surface supérieure 80 du support CMOS 8, une dixième couche 535 (dont seule une partie 535C subsiste en fin d'étape et est visible), constituée d'une photorésine de photolithographie. On utilise, de préférence, la même résine que celle employée à l'étape exposée en relation avec la figure 19 pour former la huitième couche 531. On effectue ensuite une deuxième opération consistant à insoler, au travers d'un masque, cette dixième couche 535 de photorésine. Puis, on élimine par solvant des parties insolées (dans le cas d'une dixième couche 535 constituée d'une résine positive) de la dixième couche 535 pour ne conserver notamment, à l'emplacement de la troisième photodiode 52C, qu'une partie 535C (non insolée) de cette dixième couche 535.

On grave ensuite des parties de la neuvième couche 533 non protégées par la partie 535C de la dixième couche 535. On pratique ainsi, dans la neuvième couche 533, des ouvertures verticales situées de part et d'autre de chacun des éléments de reprise de contact 82A et 82C. On forme ainsi la couche active 520C du troisième photodétecteur 52C.

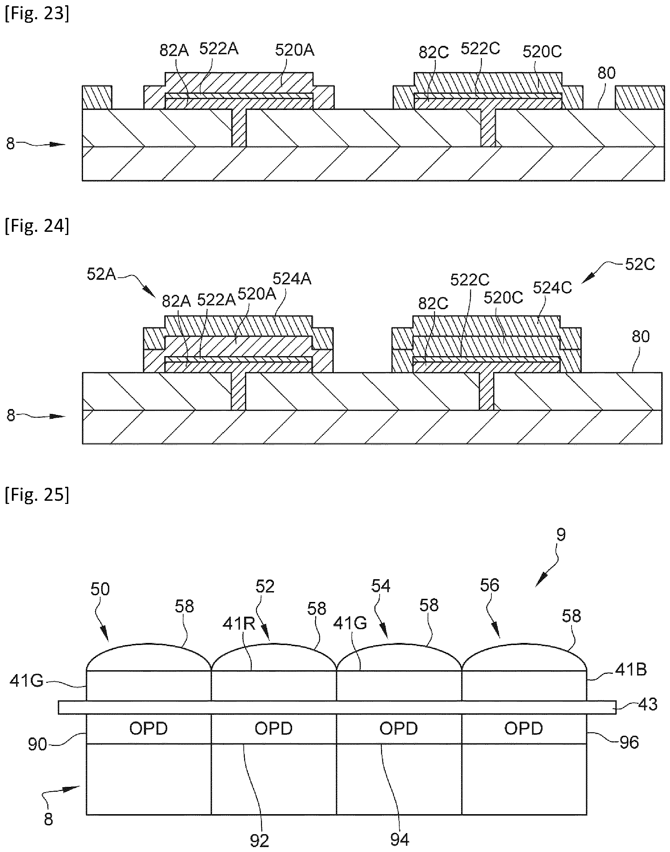

La figure 23 est une vue en coupe, schématique et partielle, d'encore une autre étape de l'autre mode de mise en œuvre du procédé de réalisation du capteur d'images 5 des figures 1 et 2 à partir de la structure telle que décrite en relation avec la figure 22.

Au cours de cette étape, on élimine les parties restantes de la huitième couche 531 et de la dixième couche 535, de préférence par trempage dans un solvant (stripping). On élimine, en particulier :

la partie 531A de la huitième couche 531, qui recouvre la couche active 520A du premier photodétecteur 52A du pixel 52 ; et

la partie 535C de la dixième couche 535, qui recouvre la couche active 520C du troisième photodétecteur 52C du pixel 52.

La figure 24 est une vue en coupe, schématique et partielle, d'encore une autre étape de l'autre mode de mise en œuvre du procédé de réalisation du capteur d'images 5 des figures 1 et 2 à partir de la structure telle que décrite en relation avec la figure 23.

Au cours de cette étape, on procède à la réalisation :

de l'électrode supérieure 524A du premier photodétecteur 52A ; et

de l'électrode supérieure 524C du troisième photodétecteur 52C.

Ces électrodes sont réalisées, de préférence, comme exposé précédemment en relation avec les figures 8 à 11. On poursuit ensuite le procédé de réalisation du capteur d'images 5 comme exposé précédemment en relation avec les figures 12 à 16.

La figure 25 est une vue en coupe, schématique et partielle, d'un autre mode de réalisation d'un capteur d'images 9.

Le capteur d'images 9 représenté en figure 25 est analogue au capteur d'images 5 exposé en relation avec les figures 1 et 2. Ce capteur d'images 9 diffère du capteur d'images 5 principalement en ce que :

les pixels 50, 52, 54 et 56 du capteur d'images 9 appartiennent à une même ligne ou à une même colonne de ce capteur d'images 9 (tandis que les pixels 50, 52, 54 et 56 du capteur d'images 5 (figure 1) sont répartis sur deux lignes et deux colonnes différentes de ce capteur d'images 5) ; et

chaque pixel 50, 52, 54 et 56 du capteur d'images 9 possède un filtre couleur 41R, 41G ou 41B sous sa microlentille 58 et sur une couche de passivation 43. En d'autres termes, les quatre pixels monochromatiques 50, 52, 54 et 56 disposés en carré en figure 1 sont ici mis côte à côte en figure 25.

Plus précisément, dans l'exemple de la figure 25, le capteur d'images 9 comporte :

un premier filtre vert 41G, intercalé entre la microlentille 58 du pixel 50 et la couche de passivation 43 ;

un filtre rouge 41R, intercalé entre la microlentille 58 du pixel 52 et la couche de passivation 43 ;

un deuxième filtre vert 41G, intercalé entre la microlentille 58 du pixel 54 et la couche de passivation 43 ; et

un filtre bleu 41B, intercalé entre la microlentille 58 du pixel 56 et la couche de passivation 43.

Selon ce mode de réalisation, les filtres couleur 41R, 41G et 41B du capteur d'images 9 laissent passer les ondes électromagnétiques dans des plages de fréquences différentes du spectre visible et laissent passer les ondes électromagnétiques du spectre infrarouge. Les filtres couleur 41R, 41G et 41B peuvent correspondre à des blocs de résine colorée. Chaque filtre couleur 41R, 41G et 41B est adapté à laisser passer le rayonnement infrarouge, par exemple à une longueur d'onde comprise entre 700 nm et 1 mm, et, pour au moins certains des filtres couleur, à laisser passer une plage de longueurs d'onde de la lumière visible.

Pour chaque pixel d'une image couleur à acquérir, le capteur d'images 9 peut comprendre :

au moins un pixel (par exemple, le pixel 56) dont le filtre couleur 41B est adapté à laisser passer le rayonnement infrarouge et la lumière bleue, par exemple dans la plage de longueurs d'onde de 430 nm à 490 nm ;

au moins un pixel (par exemple, les pixels 50 et 54) dont le filtre couleur 41G est adapté à laisser passer le rayonnement infrarouge et la lumière verte, par exemple dans la plage de longueurs d'onde de 510 nm à 570 nm ; et

au moins un pixel (par exemple, le pixel 52) dont le filtre couleur 41R est adapté à laisser passer le rayonnement infrarouge et la lumière rouge, par exemple dans la plage de longueurs d'onde de 600 nm à 720 nm.

De façon analogue au capteur d'images 5 exposé en relation avec les figures 1 et 2, chaque pixel 50, 52, 54, 56 du capteur d'images 9 dispose d'un premier et d'un deuxième photodétecteur, ces premier et deuxième photodétecteurs étant adaptés à évaluer une distance par temps de vol, et de deux troisièmes photodétecteurs adaptés à capturer une image. Chaque pixel comporte ainsi quatre photodétecteurs, représentés de façon très schématique en figure 25 par un même bloc (OPD). Plus précisément, en figure 25 :

le pixel 50 comporte quatre photodétecteurs organiques (bloc 90, OPD) ;

le pixel 52 comporte quatre photodétecteurs organiques (bloc 92, OPD) ;

le pixel 54 comporte quatre photodétecteurs organiques (bloc 94, OPD) ; et

le pixel 56 comporte quatre photodétecteurs organiques (bloc 96, OPD).

Les photodétecteurs de chaque pixel 50, 52, 54 et 56 sont coplanaires et associés chacun à un circuit de lecture comme exposé en relation avec la figure 3. Ces circuits de lecture sont réalisés sur et à l'intérieur du support CMOS 8. Le capteur d'images 9 est ainsi capable, par exemple, de réaliser alternativement des estimations de distance par temps de vol et des captures d'images en couleur.

Selon un mode de réalisation, les couches actives des premiers, deuxièmes et troisièmes photodétecteurs des pixels du capteur d'images 9 sont constituées d'un même matériau capable d'absorber les ondes électromagnétiques du spectre visible et d'une partie du spectre infrarouge, de préférence l'infrarouge proche. On peut alors utiliser le capteur d'images 9 pour réaliser alternativement :

des évaluations de distance par temps de vol grâce aux premiers et deuxièmes photodétecteurs en les pilotant, par exemple, comme exposé en relation avec la figure 4 ; et

des images en couleur grâce aux troisièmes photodétecteurs en pilotant ces troisièmes photodétecteurs, par exemple, de façon synchronisée.

Un avantage de ce mode de réalisation est que le capteur d'images 9 présente alors une plus grande sensibilité car les quatre photodétecteurs de chaque pixel sont mis à contribution lors de la réalisation de l'image couleur.

Selon un autre mode de réalisation, les couches actives des premiers et deuxièmes photodétecteurs des pixels du capteur d'images 9 sont constituées d'un matériau différent de celui dont sont constituées les couches actives des troisièmes photodétecteurs. Selon cet autre mode de réalisation :

le matériau dont sont constituées les couches actives des premiers et deuxièmes photodétecteurs est capable d'absorber les ondes électromagnétiques d'une partie du spectre infrarouge, de préférence l'infrarouge proche ; et

le matériau dont sont constituées les couches actives des troisièmes photodétecteurs est capable d'absorber les ondes électromagnétiques du spectre visible, tout en étant transparent au rayonnement proche infrarouge.

On peut alors utiliser le capteur d'images 9 pour réaliser simultanément ou alternativement :

des évaluations de distance par temps de vol grâce aux premiers et deuxièmes photodétecteurs en les pilotant, par exemple, comme exposé en relation avec la figure 4 ; et

des images en couleur grâce aux troisièmes photodétecteurs en pilotant ces troisièmes photodétecteurs, par exemple, de façon synchronisée.

Un avantage de cet autre mode de réalisation est que le capteur d'images 9 est alors capable de superposer, sur une image couleur, des informations issues de l'évaluation de distance par temps de vol. On peut ainsi imaginer un mode de mise en œuvre du fonctionnement du capteur d'images 9 permettant, par exemple, de produire une image couleur d'un sujet et d'inclure, pour chaque pixel de cette image couleur, une information représentative de la distance séparant le capteur d'images 9 de la zone du sujet représentée par le pixel considéré. En d'autres termes, le capteur d'images 9 peut réaliser une image tridimensionnelle d'une surface d'un objet, d'un visage, d'une scène, etc.

Divers modes de réalisation, modes de mise en œuvre et variantes ont été décrits. L'homme de l'art comprendra que certaines caractéristiques de ces divers modes de réalisation, modes de mise en œuvre et variantes pourraient être combinées, et d'autres variantes apparaîtront à l'homme de l'art.

Enfin, la mise en œuvre pratique des modes de réalisation, modes de mise en œuvre et variantes décrits est à la portée de l'homme du métier à partir des indications fonctionnelles données ci-dessus. En particulier, l'adaptation du pilotage des circuits de lecture des capteurs d'images 5 et 9 à d'autres modes de fonctionnement, par exemple pour la réalisation d'images infrarouges avec ou sans lumière ajoutée, la réalisation d'images avec suppression de fond et la réalisation d'images à grande gamme dynamique (HDR simultané) est à la portée de l'homme du métier à partir des indications ci-dessus.

## Revendications

1.  Pixel (50, 52, 54, 56) comportant :

un support CMOS (8) ;

exactement un premier photodétecteur organique (50A, 52A, 54A, 56A), un deuxième photodétecteur organique (50B, 52B, 54B, 56B) et deux troisièmes photodétecteurs organiques (50C, 50D, 52C, 52D, 54C, 54D, 56C, 56D), chaque photodétecteur organique comportant une première électrode (502A, 502B, 502C, 502D, 522A, 522B, 522C, 522D, 542A, 542B, 542C, 542D, 562A, 562B, 562C, 562D), distincte de premières électrodes des autres photodétecteurs organiques, formée en surface (80) du support CMOS ; et

une même lentille (58) à l'aplomb des premier, deuxième et troisièmes photodétecteurs organiques,

dans lequel le premier photodétecteur organique est connecté à une deuxième électrode (504A, 524A, 544A, 564A), le deuxième photodétecteur organique est connecté à une troisième électrode (504B, 524B, 544B, 564B) et les troisièmes photodétecteurs organiques sont connectés à une même quatrième électrode (536, 5360, 5362).

2. Capteur d'images (5 ; 9) comportant plusieurs pixels (50, 52, 54, 56) selon la revendication 1.

3. Procédé de fabrication d'un pixel selon la revendication 1 ou d'un capteur d'images selon la revendication 2, comprenant des étapes consistant à :

> prévoir le support CMOS (8) ;
> réaliser les premier (50A, 52A, 54A, 56A), deuxième (50B, 52B, 54B, 56B) et troisièmes (50C, 50D, 52C, 52D, 54C, 54D, 56C, 56D) photodétecteurs organiques du ou de chaque pixel ; et
> réaliser la lentille (58) à l'aplomb des premier, deuxième et troisièmes photodétecteurs organiques du ou de chaque pixel.

4. Pixel selon la revendication 1 ou capteur selon la revendication 2 ou procédé selon la revendication 3, dans lequel les premier (50A, 52A, 54A, 56A), deuxième (50B, 52B, 54B, 56B) et troisièmes (50C, 50D, 52C, 52D, 54C, 54D, 56C, 56D) photodétecteurs organiques sont coplanaires.

5. Pixel selon la revendication 1 ou 4, ou capteur selon la revendication 2 ou 4, ou procédé selon la revendication 3 ou 4, dans lequel les premier (50A, 52A, 54A, 56A), deuxième (50B, 52B, 54B, 56B) et troisièmes (50C, 50D, 52C, 52D, 54C, 54D, 56C, 56D) photodétecteurs organiques sont séparés les uns des autres par un diélectrique (528, 508C, 528C).

6. Pixel selon la revendication 1, 4 ou 5, ou capteur selon la revendication 2, 4 ou 5, ou procédé selon l'une quelconque des revendications 3 à 5, dans lequel chaque première électrode (502A, 502B, 502C, 502D, 522A, 522B, 522C, 522D, 542A, 542B, 542C, 542D, 562A, 562B, 562C, 562D) est reliée, de préférence connectée, à un circuit de lecture (60A, 60B, 60C, 60D), chaque circuit de lecture comportant, de préférence, trois transistors (200, 202, 210) formés dans le support CMOS (8).

7. Pixel selon l'une quelconque des revendications 1, 4 à 6, ou capteur selon l'une quelconque des revendications 2, 4 à 6, ou procédé selon l'une quelconque des revendications 3 à 6, dans lequel les premier (50A, 52A, 54A, 56A), deuxième (50B, 52B, 54B, 56B) et troisièmes (50C, 50D, 52C, 52D, 54C, 54D, 56C, 56D) photodétecteurs organiques sont adaptés à évaluer une distance par temps de vol.

8. Pixel selon l'une quelconque des revendications 1, 4 à 7, ou capteur selon l'une quelconque des revendications 2, 4 à 7, ou procédé selon l'une quelconque des revendications 3 à 7, dans lequel, pour chaque pixel (50, 52, 54, 56), le premier photodétecteur organique (50A, 52A, 54A, 56A), le deuxième photodétecteur organique (50B, 52B, 54B, 56B) et les troisièmes photodétecteurs organiques (50C, 50D, 52C, 52D, 54C, 54D, 56C, 56D) sont de forme carrée et s'inscrivent conjointement dans un carré.

9. Pixel selon l'une quelconque des revendications 1, 4 à 8, ou capteur selon l'une quelconque des revendications 2, 4 à 8, ou procédé selon l'une quelconque des revendications 3 à 8, dans lequel :

> le premier photodétecteur organique (50A, 52A, 54A, 56A) et le deuxième photodétecteur organique (50B, 52B, 54B, 56B) comportent une première couche active (500A, 520A, 540A, 560A, 500B, 520B, 540B, 560B) constituée d'un même premier matériau ; et
> les troisièmes photodétecteurs organiques (50C, 50D, 52C, 52D, 54C, 54D, 56C, 56D) comportent une deuxième couche active (500C, 520C, 540C, 560C, 500D, 520D, 540D, 560D) constituée d'un deuxième matériau.

10. Pixel, capteur ou procédé selon la revendication 9, dans lequel le premier matériau est identique au deuxième matériau, ledit matériau étant adapté à absorber les ondes électromagnétiques du spectre visible et d'une partie du spectre infrarouge.

11. Pixel, capteur ou procédé selon la revendication 9, dans lequel le premier matériau est différent du deuxième matériau, ledit premier matériau étant adapté à absorber les ondes électromagnétiques d'une partie du spectre infrarouge et ledit deuxième matériau étant adapté à absorber les ondes électromagnétiques du spectre visible.

12. Pixel selon l'une quelconque des revendications 1, 4 à 11, ou capteur selon l'une quelconque des revendications 2, 4 à 11, adapté à fonctionner :

> dans une partie du spectre infrarouge ;
> en lumière structurée ;
> en imagerie à grande gamme dynamique, HDR ; et/ou
> avec suppression de fond.

13. Capteur selon l'une quelconque des revendications 2, 4 à 12, dans lequel chaque pixel (50, 52, 54, 56) comporte en outre, sous la lentille (58), un filtre couleur (41R, 41G, 41B) laissant passer les ondes électromagnétiques dans une plage de fréquences du spectre visible et dans le spectre infrarouge.

**14.** Capteur selon la revendication 13, adapté à capter une image couleur.

**15.** Capteur selon l'une quelconque des revendications 2, 4 à 14, dans lequel :

la deuxième électrode (504A, 524A, 544A, 564A) est commune à tous les premiers photodétecteurs organiques (50A, 52A, 54A, 56A) des pixels (50, 52, 54, 56) du capteur (5 ; 9) ;
la troisième électrode (504B, 524B, 544B, 564B) est commune à tous les deuxièmes photodétecteurs organiques (50B, 52B, 54B, 56B) des pixels du capteur ; et
la quatrième électrode (536, 5360, 5362) est commune à tous les troisièmes photodétecteurs organiques (50C, 50D, 52C, 52D, 54C, 54D, 56C, 56D) des pixels du capteur.

[Fig. 1]

[Fig. 2]

[Fig. 3]

[Fig. 4]

[Fig. 5]

[Fig. 6]

[Fig. 7]

[Fig. 8]

[Fig. 9]

[Fig. 10]

[Fig. 11]

[Fig. 12]

[Fig. 13]

[Fig. 14]

[Fig. 15]

[Fig. 16]

[Fig. 17]

(A)                                    (B)                                    (C)

EP 3 767 678 A1

[Fig. 18]

[Fig. 19]

[Fig. 20]

[Fig. 21]

[Fig. 22]

[Fig. 23]

82A  522A  520A          82C  522C  520C     80

8 →

[Fig. 24]

52A     82A  522A 520A  524A          522C  520C  524C     52C

82C     80

8 →

[Fig. 25]

9

50     58     52     58     54     58     56     58

41R           41G                   41B

41G                                        43

OPD     OPD     OPD     OPD

90                                         96

8

92     94

Europäisches
Patentamt

European
Patent Office

Office européen
des brevets

## RAPPORT DE RECHERCHE EUROPEENNE

Numéro de la demande

EP 20 18 6099

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | DE 10 2016 102111 A1 (SAMSUNG ELECTRONICS CO LTD [KR]) 18 août 2016 (2016-08-18) | 1-4 | INV. H01L27/30 |
| A | * alinéa [0187] - alinéa [0193]; figure 17 * | 5-15 | H01L51/44 |
| | * alinéas [0081], [0083], [0181], [0197], [0228] - [0230] * | | H04N5/369 H01L27/146 |
| | * alinéa [0161] - alinéa [0169]; figures 14,15B * | | |
| | ----- | | |
| A | US 2017/257587 A1 (HATANO KEISUKE [JP] ET AL) 7 septembre 2017 (2017-09-07) | 1-15 | |
| | * alinéa [0176]; figure 16 * | | |
| | * alinéa [0078] * | | |
| | * figure 3 * | | |
| | ----- | | |
| A | EP 3 209 012 A1 (SAMSUNG ELECTRONICS CO LTD [KR]) 23 août 2017 (2017-08-23) | 6 | |
| | * alinéa [0104] - alinéas [0110], [0116]; figures 9A,9C * | | |
| | * alinéas [0049], [0068], [0091] * | | |
| | ----- | | |

**DOMAINES TECHNIQUES RECHERCHES (IPC)**

H01L
H04N

Le présent rapport a été établi pour toutes les revendications

| Lieu de la recherche | Date d'achèvement de la recherche | Examinateur |
|---|---|---|
| Munich | 30 septembre 2020 | Pusch, Catharina |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................
& : membre de la même famille, document correspondant

**ANNEXE AU RAPPORT DE RECHERCHE EUROPEENNE
RELATIF A LA DEMANDE DE BREVET EUROPEEN NO.**

EP 20 18 6099

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

30-09-2020

| Document brevet cité au rapport de recherche | Date de publication | Membre(s) de la famille de brevet(s) | Date de publication |
|---|---|---|---|
| DE 102016102111 A1 | 18-08-2016 | CN 105898118 A | 24-08-2016 |
| | | DE 102016102111 A1 | 18-08-2016 |
| | | JP 6709632 B2 | 17-06-2020 |
| | | JP 2016152417 A | 22-08-2016 |
| | | KR 20160100569 A | 24-08-2016 |
| | | US 2016240571 A1 | 18-08-2016 |
| | | US 2017358615 A1 | 14-12-2017 |
| US 2017257587 A1 | 07-09-2017 | JP 2016058559 A | 21-04-2016 |
| | | US 2017257587 A1 | 07-09-2017 |
| | | US 2019098239 A1 | 28-03-2019 |
| | | US 2020195869 A1 | 18-06-2020 |
| | | WO 2016039152 A1 | 17-03-2016 |
| EP 3209012 A1 | 23-08-2017 | CN 107105130 A | 29-08-2017 |
| | | EP 3209012 A1 | 23-08-2017 |
| | | KR 20170098089 A | 29-08-2017 |
| | | US 2017243367 A1 | 24-08-2017 |
| | | WO 2017142342 A1 | 24-08-2017 |

EPO FORM P0460

Pour tout renseignement concernant cette annexe : voir Journal Officiel de l'Office européen des brevets, No.12/82

**EP 3 767 678 A1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 102016102111
- US 2017257587 A
- EP 3209012 A